(19) Europäisches Patentamt
European Patent Office
Office européen des brevets

(11) **EP 4 280 287 A1**

(12) **EUROPEAN PATENT APPLICATION**
published in accordance with Art. 153(4) EPC

(43) Date of publication:
**22.11.2023 Bulletin 2023/47**

(21) Application number: **22739534.0**

(22) Date of filing: **18.01.2022**

(51) International Patent Classification (IPC):
***H01L 29/786*** *(2006.01)* ***G01N 27/414*** *(2006.01)*

(52) Cooperative Patent Classification (CPC):
**G01N 27/414; H01L 29/786**

(86) International application number:
**PCT/JP2022/001655**

(87) International publication number:
**WO 2022/154129 (21.07.2022 Gazette 2022/29)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.01.2021 JP 2021006049**
**01.02.2021 JP 2021014676**

(71) Applicant: **The University of Tokyo**
**Bunkyo-ku, Tokyo 113-8654 (JP)**

(72) Inventors:
- **SAKATA, Toshiya**
  **Tokyo 113-8654 (JP)**
- **SHIRATORI, Reiko**
  **Tokyo 113-8654 (JP)**
- **NISHITANI, Shoichi**
  **Tokyo 113-8654 (JP)**

(74) Representative: **Michalski Hüttermann & Partner Patentanwälte mbB**
**Kaistraße 16A**
**40221 Düsseldorf (DE)**

# (54) THIN FILM, BIOSENSOR, AND METHOD FOR MANUFACTURING SAME

(57) The present disclosure provides a novel method for producing a thin film in which the denseness of the thin film can be controlled. A method according to the present disclosure relates to a method for producing a thin film, including the steps (a) to (e) in this order: (a) providing an electrically conductive substrate; (b) using a first precursor to form a first layer on a surface of the electrically conductive substrate; (c) removing at least part of an unreacted material from the first layer; (d) electrochemically bonding a second precursor onto a surface of the electrically conductive substrate or to the first layer to form a second layer; and (e) repeating the steps (c) and (d).

*FIG.3*

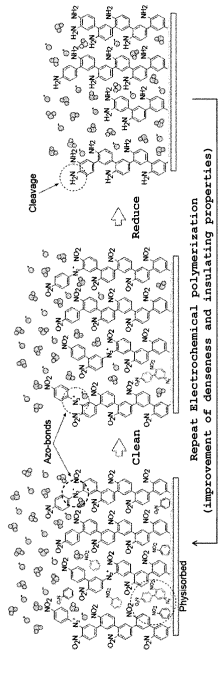


EP 4 280 287 A1

## Description

### Technical Field

The present invention relates to a thin film, a biosensor, and a method for producing them. In particular, the present invention relates to a thin film on the surface of an electrode of an electrochemical biosensor, a biosensor, and a method for producing them.

### Background Art

Biological fluids, such as blood, tears, sweat, and saliva, contain various biomolecules. The development of a biosensor that can easily, selectively, and sensitively recognize a biomarker related to a disease by using such a biomolecule as a biomarker will lead to health maintenance, such as early detection and prevention of various diseases, and greatly contribute to the development of next-generation medical care.

Health care using a wearable sensor, such as a heart rate monitor with an optical sensor, is becoming very familiar. However, sufficient resolution has not been achieved for the selective recognition of a specific biomarker from a biological fluid containing various biomolecules and ions, and health care using a biosensor for a biological fluid is not yet familiar.

On the other hand, electrochemical biosensors are expected to be put into practical use because they enable the detection of a biomarker selectively and directly from an electrical signal through a redox reaction or by binding to a specific receptor molecule. However, further development of the technology is required for practical use due to biofouling in which a protein contained in a large amount in a biological fluid is adsorbed on an electrode surface and reduces sensitivity and durability.

In recent years, it has been found that an extended Au-gate FET biosensor as described in Patent Literature 1 can detect various low-molecular-weight biomarkers with high sensitivity. It has become clear that various biomolecules can be measured with high sensitivity by using an extended gate electrode functioning as a redox catalyst. However, various biomolecules undergo a redox reaction with an electrode, and appropriate interfacial modification is therefore required to achieve a high signal-to-noise ratio. Thus, a sensor/interface design based on this has been reported.

In particular, the signal-to-noise ratio of a specific biological low-molecular-weight compound has been improved by preparing a nanofilter for trapping contaminants on the surface of a Au electrode and designing the nanofilter so that only a target molecule of a biomarker can permeate the nanofilter and reach the surface of the Au electrode [Non-Patent Literature 1].

In particular, it has also been reported that a filtering effect can be achieved by chemically modifying an anchor layer, which is formed by forming a thin film of a diazonium salt nitrobenzene diazonium (NBD) by electrochemical modification on an electrode surface, with a thin film, an aptamer molecule, or the like containing phenylboronic acid (PBA) as a receptor for contaminants [Non-Patent Literature 2] .

A PPC thin film containing phenylphosphorylcholine (PPC) with a highly hydrophilic bipolar phosphorylcholine group has also been proposed to provide an anti-fouling effect against the biofouling [Non-Patent Literature 3].

Furthermore, Patent Literature 2 discloses bonding a diazonium compound on an electrode surface of an FET biosensor to form a layer derived from the diazonium compound and forming a polymer chain in the layer by atom transfer radical polymerization. The polymer layer thus formed has a high filtering effect.

A known electrochemical biosensor is not only an FET biosensor as described above but also a biosensor based on a cyclic voltammetry method as described in Non-Patent Literature 4 or a biosensor based on an electrochemical impedance spectroscopy (EIS) method as described in Non-Patent Literature 5.

### Citation List

#### Patent Literature

PTL 1: Japanese Unexamined Patent Application Publication No. 2014-215292
PTL 2: Japanese Unexamined Patent Application Publication No. 2019-45417

#### Non Patent Literature

NPL 1: Nishitani, S. et al., ACS Applied Materials & Interfaces, 2019, 11, 5561-5569
NPL 2: Himori, S. et al., Langmuir, 2019, 35, 3701-3709
NPL 3: Parviz, M. et al., Electroanalysis, 2014, 26, 1471-1480
NPL 4: Thiagarajan, S. et al., Biosensors and Bioelectronics, 2009, 24, 8, 2712-2715
NPL 5: Garrote, B. et al., Nature Protocols, 15, 3879-3893 (2020)

## Summary of Invention

### Technical Problem

The present invention provides a novel method for producing a thin film, the denseness of which can be controlled, and a dense thin film produced by such a method.

### Solution to Problem

The present inventors have found that the above objects can be achieved by the following aspects of the present invention.

«Aspect 1» A method for producing a thin film, including the steps (a) to (e) in this order:

(a) providing an electrically conductive substrate;
(b) using a first precursor to form a first layer on a surface of the electrically conductive substrate;
(c) removing at least part of an unreacted material from the first layer;
(d) electrochemically bonding a second precursor onto a surface of the electrically conductive substrate or to the first layer to form a second layer; and
(e) repeating the steps (c) and (d).

«Aspect 2» The production method according to Aspect 1, wherein the step (e) is repeated two or more times.
<<Aspect 3>> The production method according to Aspect 1 or 2, wherein the step (c) is electrochemically performed.
<<Aspect 4>> The production method according to Aspect 1 or 2, wherein the step (c) is performed by ultrasonic cleaning.
<<Aspect 5>> The production method according to any one of Aspects 1 to 4, wherein the first and second precursors are the same material.
<<Aspect 6>> The production method according to any one of Aspects 1 to 5, wherein the first and second precursors are each individually selected from diazo aromatic compounds.
<<Aspect 7>> The production method according to any one of Aspects 1 to 6, wherein the first and second precursors are nitrophenyl diazonium, and the first and second layers are converted into an aminophenyl group by electrochemical reduction treatment.
<<Aspect 8>> The production method according to any one of Aspects 1 to 7, wherein the electrically conductive substrate is an electrode of an electrochemical biosensor, and the thin film is formed on a surface of the electrode.
«Aspect 9» A method for producing an electrochemical biosensor including an electrode, the method including: forming the thin film on a surface of the electrode by the method according to Aspect 8.
«Aspect 10» The method for producing an electrochemical biosensor according to Aspect 9, further including a field-effect transistor including the electrode, or a field-effect transistor including a gate electrode coupled to the electrode.
«Aspect 11» A thin film including:

a layer with an aminophenyl group,
wherein the aminophenyl group has a denseness of 10 molecules/$nm^2$ or more.

«Aspect 12» The thin film according to Aspect 11, wherein the thin film has a thickness of 10 nm or less.
<<Aspect 13>> The thin film according to Aspect 11 or 12, wherein the thin film has a charge transfer resistance ($R_{ct}$) of 50 $\Omega \cdot cm^2$ or more.
<<Aspect 14» An electrochemical biosensor including the thin film according to any one of Aspects 11 to 13 on a surface of an electrode.
<<Aspect 15» The electrochemical biosensor according to Aspect 14, further including a field-effect transistor including the electrode, or a field-effect transistor including a gate electrode coupled to the electrode.

Advantageous Effects of Invention

Thin films with various denseness based on various materials can be produced by a method according to the present invention. For example, in the field of biosensors, controlling the denseness of a thin film allows only a specific target molecule to permeate the thin film and reach an electrode, which is highly advantageous for the design of a biosensor. Furthermore, a thin film with a denseness level that has not been achieved by the related art can be produced by this method.

Brief Description of Drawings

[Fig. 1] Fig. 1 is a schematic view of a biosensor including a field-effect transistor.
[Fig. 2] Fig. 2 is a graph of CV waveforms (A: continuous modification (Comparative Example), B: iterative modification (Example)) in the formation (modification) of a NBD thin film.
[Fig. 3] Fig. 3 is a schematic view of an iterative process of electrochemical modification and reduction from a nitrophenyl thin film to an aminophenyl thin film.
[Fig. 4] Fig. 4 is a graph of CV waveforms in the reduction of a nitrophenyl thin film of Comparative Example.
[Fig. 5] Fig. 5 is a graph of the results of quantitative evaluation of an aminophenyl group in aminophenyl thin films prepared by iterative modification (Example) and continuous modification (Comparative Example).
[Fig. 6] Fig. 6 is a Nyquist plot of alternating-current impedance measurement in 0 to 3 iterative modifications.
[Fig. 7] Fig. 7 is a graph of the evaluation results of probe ion permeability of a nitrophenyl thin film and an aminophenyl thin film.
[Fig. 8] Fig. 8 is a graph of CV waveforms in phenylboronic acid pinacolate modification.
[Fig. 9] Fig. 9 is a graph of CV waveforms in the second, fourth, and eighth modifications during phenylboronic acid pinacolate iterative modification.
[Fig. 10] Fig. 10 is a graph of the evaluation results of probe ion permeability of a PBA thin film in each iterative modification.
[Fig. 11] Fig. 11 is a Nyquist plot of the alternating-current impedance of a pinacol-eliminated PBA thin film electrode and a pinacol-uneliminated PBA thin film electrode.
[Fig. 12] Fig. 12 is a diagram of a source follower circuit of FET used for measuring FET response.
[Fig. 13] Fig. 13 is a graph of CV waveforms in the production of a PPC thin film.
[Fig. 14] Fig. 14 is a graph of CV waveforms in the production of a PPC thin film.
[Fig. 15] Fig. 15 is a graph of the contact angle measurement of a PPC thin film.
[Fig. 16] Fig. 16 is a graph of the charge transfer resistance ($R_{ct}$) of a PPC thin film.
[Fig. 17] Fig. 17 is a graph of the results of the FET response of a PPC thin film to a biomolecule.
[Fig. 18] Fig. 18 is a graph of the results of norepinephrine-added FET measurement in a HSA environment.
[Fig. 19] Fig. 19 is a graph of the charge transfer resistance ($R_{ct}$) of a PPC/PBA mixed thin film electrode and the like.
[Fig. 20] Fig. 20 is a graph of the charge transfer resistance ($R_{ct}$) of a PPC/PBA mixed thin film electrode and the like.
[Fig. 21] Fig. 21 is a graph of the results of the FET response of a PPC/PBA mixed thin film to norepinephrine.

Description of Embodiments

<<Method for Producing Thin Film>>

A production method according to the present disclosure is a method for producing a thin film, including the steps (a) to (e) in this order:

(a) providing an electrically conductive substrate;
(b) using a first precursor to form a first layer on a surface of the electrically conductive substrate;
(c) removing at least part of an unreacted material from the first layer;
(d) electrochemically bonding a second precursor onto a surface of the electrically conductive substrate or to the first layer to form a second layer; and
(e) repeating the steps (c) and (d).

Heretofore, the step (b) has been repeatedly performed for lamination, or the steps (b) and (d) have been repeatedly performed for lamination, and finally the step (c) has been performed to produce a thin film. On the other hand, the present inventors have found that repeating the removal of an unreacted material and an electrochemical

reaction as one set (hereinafter also referred to as "iterative modification") during electrochemical lamination causes a significant difference in the electrical characteristics of the resulting thin film. Further investigation by the present inventors showed that this difference in characteristics is attributable to the denseness of the resulting thin film.

It has been found that, in continuous electrochemical lamination followed by final removal of an unreacted material (hereinafter also referred to as "continuous modification"), while a precursor is reacted and deposited, the unreacted material remains as a physisorbed species in a layer and retards the reaction. In a method according to the present invention, it is thought that the resulting thin film is densified because a second layer is easily formed by removing such a physisorbed species and the like before an electrochemical reaction.

For example, a thin film formed on an electrode surface of an electrochemical biosensor should allow the electrode to detect only a target molecule without being affected by contaminants. These characteristics required for a thin film are greatly related to the denseness of the thin film, and the ability to control the denseness of the thin film is therefore very advantageous in the design of a biosensor.

A thin film produced by a method according to the present disclosure can provide denseness and high insulating properties. For example, a thin film formed on the surface of an electrode of an electrochemical biosensor allows a probe ion to permeate the thin film without influence of contaminants on the electrode.

In a thin film (anchor layer) produced by a method according to the present disclosure, for example, controlling the denseness (surface density) of a thin film on an electrode that is an electrically conductive substrate can be expected to provide a thin film containing a receptor molecule effective for a filtering effect with a further filtering effect. Furthermore, functionalizing a molecule (for example, an aryl group) constituting the thin film allows a design to provide a thin film itself with a filtering or anti-fouling effect.

<Step (a): Provision of Electrically Conductive Substrate>

In the step (a), an electrically conductive substrate is provided. The electrically conductive substrate may be an electrode, which may be an electrode of an electrochemical biosensor.

<Step (b): Formation of First Layer>

In the step (b) of a method according to the present disclosure, a first precursor is used to form a first layer on the surface of the electrically conductive substrate. The first precursor for forming the first layer may be of any type that can be directly bonded or attached to the electrically conductive substrate. The first layer may be a monomolecular layer or a multimolecular layer in which a plurality of first precursors are bonded together.

For example, the first precursor may be a compound that can generate a radical and thereby form the first layer on the surface of the electrically conductive substrate. To allow the first precursor to generate a radical, an electric potential may be applied from the electrically conductive substrate to allow the first precursor to electrochemically generate a radical, or a material that generates a radical by heating or photoirradiation may be used as the first precursor.

Examples of the first precursor include thiol compounds, disulfide compounds, vinyl compounds, diazonium compounds, and peroxides. These may be used alone or in combination. When the electrically conductive substrate is an electrode, and the electrode is a metal electrode, such as Au, Ag, or Cu, or a carbon (GC) electrode, a diazonium compound (salt) can be used as the first precursor. Forming the first layer using a diazonium compound can fix the first layer to the surface of Au or the like by a strong covalent bond through a -C- bond.

The diazonium compound may be any diazonium compound from which a diazo group can be eliminated to generate a radical, thereby forming the first layer on the surface of the electrically conductive substrate, and may be a cyclic compound with a diazo group, such as a diazo aromatic compound, a diazoalicyclic compound, or a diazoheterocyclic compound. The diazo aromatic compound may particularly be an aryldiazonium salt. These compounds may be directly used or may be used as diazonium compounds, for example, produced by in-situ diazotization of amine compounds (for example, aromatic amines).

From the perspective of reactivity with the second precursor for forming the second layer and the like, the first precursor may have a substituent (particularly a p-substituent in the case of a cyclic compound). Examples of such a substituent include acidic groups, basic groups, and amphoteric functional groups. Examples of the acidic groups include a sulfonate group, a carboxy group, a hydroxy group, a nitro group, boron-containing groups, such as a boronate group, phosphorus-containing groups, such as a phosphonate group, and groups containing these. Examples of the basic groups include an amino group, an ammonium group, and groups containing these. Examples of the amphoteric functional groups include a phosphorylcholine group. These functional groups may be introduced to form an additional layer on the thin film or to function as receptors to trap low-molecular-weight contaminants in the thin film. The thin film can have a functional group (an amino group, a carboxy group, a boronate group, or the like) to chemically fix various probe ions (probe molecules) or the like and can have a functional group for surface modification (a phosphorylcholine group, a hydroxy group, or the like), such as hydrophilicity or hydrophobicity.

The diazonium compound can be bonded to the surface of the electrically conductive substrate via a reactive carbon radical. A carbon radical can be electrochemically formed and can be bonded to the surface of the electrically conductive substrate by applying an electric potential in an aqueous solvent or an organic solvent. When an aryldiazonium salt is used as the first precursor, a reduction potential may be applied, and a fixed potential may be applied for a certain period, or a potential cycle of a CV method or the like may be scanned for several cycles, to generate an aryl radical and bind the aryl radical to the surface of the electrically conductive substrate.

When an aryldiazonium salt is used as the first precursor, the reaction can be schematically shown below.

[Chem. 1]

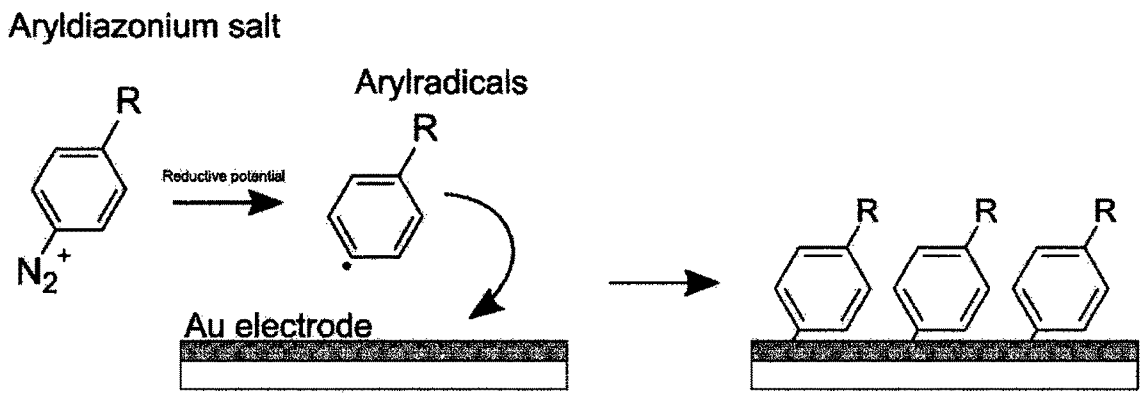


Advantages of electrochemical surface modification with such a diazonium compound, particularly an aryldiazonium salt, include: a convenient and rapid modification method; applicability to various substrate surfaces, such as carbon, metals, and semiconductors; flexibility in designing a substituent (particularly a p-substituent) of the diazonium compound to introduce a functional group; and formation of a strong covalent bond between the aryl and the surface of the electrically conductive substrate.

To control a radical reaction of the first precursor to adjust the thickness of the first layer, a radical scavenger or a chain transfer agent may be used during the formation of the first layer. For example, a radical scavenger as described in Non-Patent Literature 2 can be used to make the first layer into a monomolecular layer or a low-molecular-weight layer. Examples of the radical scavenger include, but are not limited to, well-known radical scavengers, such as 2,2-diphenyl-1-picrylhydrazyl (DPPH), hydroquinone, 4-methoxyphenol, and amine-N-oxide.

For example, to change the degree of densification of the first layer, as schematically shown below, a thiol compound may be used in combination with a diazonium compound as a first precursor to form the first layer, and then only the thiol compound portion may be destroyed by ultraviolet radiation.

[Chem. 2]

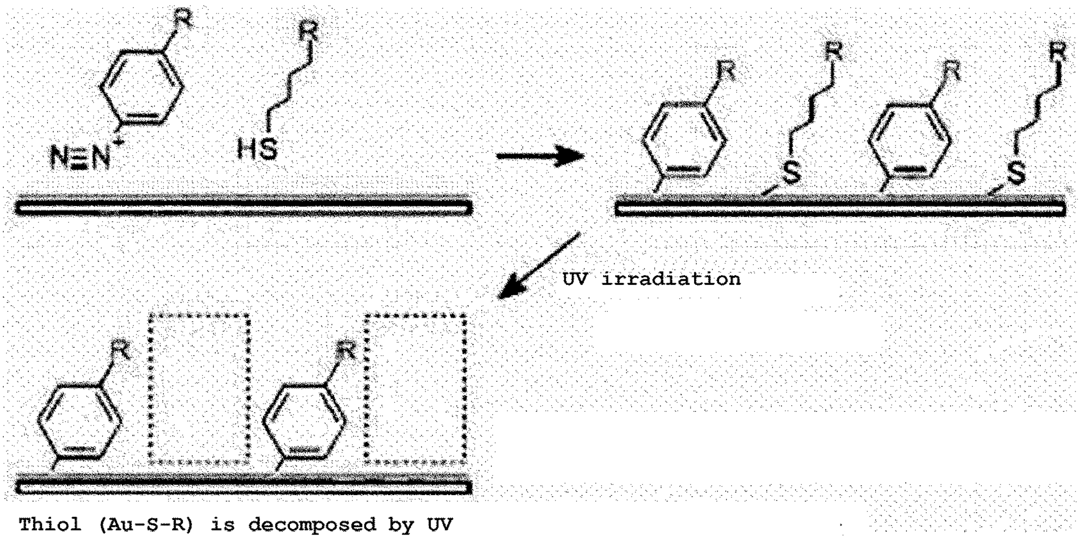


In such a case, in addition to the formation of a layer derived from a diazonium compound salt as described above, a layer due to a -S- bond derived from a thiol group is also formed. Because the -S- bond can be decomposed by ultraviolet (UV) radiation, the layer portion derived from the -S- bond can be removed to leave only the layer portion derived from the diazonium compound salt. Thus, the ratio of the diazonium compound salt to a compound with a thiol group can be adjusted to control the density of the first layer.

<Step (c): Removal of Unreacted Material>

In the step (c) of a method according to the present disclosure, an unreacted material of the first precursor (and the second precursor in the second and subsequent steps (c)) is removed. In the step (c), not only the unreacted material but also a by-product produced by a reaction of the first precursor (and/or the second precursor), for example, in the form of a radical with another material is removed.

The method of removing an unreacted material may be any method, for example, applying an electric potential to electrochemically release the unreacted material from the first layer (and/or the second layer) or removing the unreacted material by cleaning, such as ultrasonic cleaning.

To electrochemically remove an unreacted material, an electric potential in a range different from the electric potential applied to electrochemically form the layer in the step (b) (and/or the step (d)) can be applied. For example, when a positive potential is applied to form a layer or when potential scanning is performed in the range of 0 to 1.0 V by the CV method, a negative potential can be applied to release an unreacted material from the first layer (and/or the second layer). When an unreacted material is removed by such a method, for example, in a layer formed with the diazo group of the diazonium compound remaining, the diazo group may be removed for further densification of an additional thin film.

To remove an unreacted material by cleaning, the cleaning method is not particularly limited. The cleaning may be simple rinsing with an aqueous solvent or an organic solvent or can be ultrasonic cleaning in these solvents.

<Step (d): Formation of Second Layer>

In the step (c) of a method according to the present disclosure, after the removal of an unreacted material, the second precursor is electrochemically bonded to the surface of the electrically conductive substrate or to the first layer to form the second layer. The second layer may be a monomolecular layer or a multimolecular layer in which a plurality of second precursors are bonded together.

In the related art, a potential cycle of the CV method or the like is scanned for several cycles to form the first and second layers from an electrochemical reaction, and ultrasonic cleaning is finally performed to remove an unreacted material. A method according to the present disclosure is characterized by the lamination step of the step (d) after the

removal of the unreacted material. Thus, this step is an essential feature of a method according to the present disclosure.

The second precursor used in the step (c) may be a different material from or the same material as the first precursor for forming the first layer. The second precursor may be electrochemically bonded to the first layer or may be bonded to the surface of the electrically conductive substrate. The second precursor may be selected from the same materials as the materials for use in the first precursor.

The same applies to the electrochemical reaction, and the second layer can be formed in the same manner as in the electrochemical reaction for forming the first layer.

<Step (e): Repetition of Steps (c) and (d)>

A method according to the present disclosure includes repeating the steps (c) and (d) to densify a thin film. The repetition can be performed at least once, once to 20 times, twice to 10 times, or 3 to 8 times. For example, in a potential cycle of the CV method or the like to electrochemically form a layer, the repetition can be performed until the waveform of the electric current does not change significantly. To electrochemically form a layer at a fixed potential, the repetition can be performed until the electric current becomes constant.

For example, in this method, the thickness may be saturated in the range of 3 to 10 nm, more specifically 6 to 8 nm, after approximately 10 iterative modifications, and the densification and insulating properties may also be saturated after approximately 10 iterative modifications.

In this repeating step, the steps (c) and (d) and the next steps (c) and (d) are not necessarily completely the same. For example, the second precursor in the step (c) may be changed in the next step (c).

In the second and subsequent steps (c), a second precursor different from the second precursor of the previous step (c) may be used to form a mixed thin film based on a different material. As disclosed in Experiment 4 in Examples, two or more different precursors can be used to provide each layer with a different function and thereby enhance the functionality of the thin film.

<Other Steps>

In a method according to the present disclosure, a layer for further providing another function can be formed on the thin film formed as described above. For example, as described in Patent Literature 2, a polymer with a boronate group can be bonded to provide a filtering effect. Alternatively, an aptamer layer that binds to a target molecule may be formed on the thin film, or a hydrophilic polymer layer, such as poly(ethylene glycol), may be formed to provide an anti-fouling effect.

<<Thin Film>>

A thin film according to the present disclosure is a thin film with high denseness as produced by a production method according to the present disclosure described above, and the constituents of a thin film according to the present disclosure can be referred to the constituents described with respect to a production method according to the present disclosure. The constituents related to a method for producing a thin film according to the present disclosure can also be referred to the constituents described below with respect to a thin film according to the present disclosure.

A thin film according to the present disclosure is formed on a surface of an electrically conductive substrate. The thin film includes a first layer that is directly bonded or attached to the electrically conductive substrate and a second layer that is bonded to a molecule of the first layer to be formed in the thickness direction or the transverse direction. The first layer and the second layer may overlap geometrically. The first layer and the second layer may be formed of the same type of molecules or different types of molecules.

The molecules constituting the first layer and the second layer can be composed of molecules derived from the first and second precursors described above, respectively, and can particularly be an aromatic compound derived from a diazo aromatic compound. The aromatic compound may have a substituent, which may be an acidic group, a basic group, or an amphoteric functional group. Examples of the acidic groups include a sulfonate group, a carboxy group, a hydroxy group, a nitro group, boron-containing groups such as a boronate group, phosphorus-containing groups such as a phosphonate group, and groups containing these. Examples of the basic groups include an amino group, an ammonium group, and groups containing these. Examples of the amphoteric functional groups include a phosphorylcholine group and the like.

In particular, a thin film according to the present disclosure can include a layer with an aminophenyl group, which can be formed by using nitrophenyl diazonium as the first and/or second precursor and then by electrochemical reduction treatment.

A thin film according to the present disclosure may have a thickness of, for example, 20 nm or less, 19 nm or less, 18 nm or less, 17 nm or less, 16 nm or less, 15 nm or less, 14 nm or less, 13 nm or less, 12 nm or less, 11 nm or

less, 10 nm or less, less than 10 nm, 9 nm or less, or 8 nm or less, and 3 nm or more, 4 nm or more, 5 nm or more, 6 nm or more, 7 nm or more, 8 nm or more, 9 nm or more, 10 nm or more, 11 nm or more, 12 nm or more, 13 nm or more, 14 nm or more, or 15 nm or more. A thin film according to the present disclosure may have a thickness of 3 nm or more and 20 nm or less, or 5 nm or more and 10 nm or less. The thickness of a thin film can be measured with an atomic force microscope.

A thin film according to the present disclosure can have high insulating properties due to high denseness, and can have a charge transfer resistance ($R_{ct}$) of 50 $\Omega \cdot cm^2$ or more, 100 $\Omega \cdot cm^2$ or more, 300 $\Omega \cdot cm^2$ or more, 500 $\Omega \cdot cm^2$ or more, 1000 $\Omega \cdot cm^2$ or more, or 1500 $\Omega \cdot cm^2$ or more, when measured by a method described in Examples.

The degree of denseness of a thin film including a layer with an aminophenyl group thus formed can be quantified from the number of amino groups by a method described in Examples. In a thin film according to the present disclosure, the denseness of the aminophenyl group may be 10 molecules/$nm^2$ or more, 15 molecules/$nm^2$ or more, or 20 molecules/$nm^2$ or more, and may be 40 molecules/$nm^2$ or less, 30 molecules/$nm^2$ or less, or 20 molecules/$nm^2$ or less. For example, the denseness of the aminophenyl group of a thin film according to the present disclosure is 10 molecules/$nm^2$ or more and 40 molecules/$nm^2$ or less. The unit "molecules/$nm^2$" is a unit in which one aminophenyl group is regarded as one molecule, and may be replaced with "functional groups/$nm^2$" regarding one aminophenyl group as one functional group.

A thin film according to the present disclosure may further include a layer for providing another function in addition to the layers described above. For example, as described in Patent Literature 2, a polymer with a boronate group can be bonded to provide a filtering effect. Alternatively, an aptamer layer that binds to a target molecule may be formed on the layer as described above, or a hydrophilic polymer layer, such as poly(ethylene glycol), may be formed to provide an anti-fouling effect.

<<Biosensor and Method for Producing the Biosensor>>

A thin film according to the present disclosure can be used for a biosensor, a chemical sensor, or the like. The biosensor can be an electrochemical biosensor including an electrode as an electrically conductive substrate. An electrochemical biosensor including an electrode may have a structure of a known biosensor except for the thin film described above on the surface of the electrode. The biosensor can also be a surface plasmon resonance (SPR) biosensor including an electrically conductive substrate, or a quartz crystal microbalance (QCM) biosensor including an electrically conductive substrate. A method for producing a biosensor is a method for producing an electrochemical biosensor including an electrode and may employ constituents of a known method for producing a biosensor except that the thin film is formed on the surface of the electrode by the method for producing a thin film.

The electrochemical biosensor may be a biosensor for detecting the presence and concentration of a material to be detected based on a current waveform of the CV method as described in Non-Patent Literature 4, a biosensor for detecting the presence and concentration of a material to be detected based on impedance measurement of an electrochemical impedance spectroscopy (EIS) method as described in Non-Patent Literature 5, or a biosensor for detecting the presence and concentration of a material to be detected based on potential measurement of a gate electrode of a field-effect transistor.

A sample for the biosensor may be blood or a noninvasively collected sample, for example, sweat, tears, or saliva.

A material to be detected with the biosensor may be a low-molecular-weight biomarker. The low-molecular-weight biomarker may typically be an amino acid, such as cysteine or tyrosine; glucose, which is closely associated with diabetes; a neurotransmitter, such as DOPA or dopamine; or a biological compound, such as histamine, which is involved in allergic response. The low-molecular-weight biomarker is not limited thereto and may also be lactic acid, uric acid, sialic acid, sialyllactose, fructose, paromomycin, kanamycin, L-epinephrine, or the like.

A material to be detected with the biosensor may be a probe ion as described above, or a biomarker may be indirectly detected using a probe ion.

A material to be detected is detected by approaching a detection region of an electrode, and the detection region is within several nanometers of the thickness of a thin film, for example, within the Debye length, typically within 5 nm. The Debye length is a region in which a potential change due to the presence of a compound can be observed near the electrode. The Debye length also depends on the solution concentration or the like in a sensing unit used for measurement and may be 1, 2, 3, or 4 nm or may range from 5 to 10 nm.

Fig. 1 illustrates a biosensor including a field-effect transistor, which is one embodiment of a biosensor according to the present disclosure.

A biosensor 10 includes a sensing unit 11 for identifying the presence of a material to be detected and a field-effect transistor (FET) 12 as a detecting unit. The biosensor 10 identifies a material to be detected in a sample in the sensing unit 11, converts the identified information into an electrical signal in the FET 12, and thereby detects the presence and concentration of the material to be detected in the sample.

Fig. 1 illustrates, as a typical example, the use of a so-called extended gate FET with a gate electrode 21

electrically connected to a metal electrode 32 through a metal wire 36, but the biosensor is not limited to such an example.

The sensing unit 11 includes the gate electrode (extended gate electrode) 21 and a thin layer 22 on the gate electrode 21. As described above, the thin layer has the function of selectively trapping or removing contaminants that generate a noise signal during the detection of the response of a target material to be detected, and thereby allows only the material to be detected to permeate the thin layer and reach the vicinity of the interface of the gate electrode 21.

In the embodiment illustrated in Fig. 1, in the sensing unit 11, a container 23 is formed by providing a cylindrical wall portion on a side surface of the gate electrode 21, and a sample containing a material to be identified is added to the container 23. The gate electrode 21 may be formed of a metal electrode, such as Au, Ag, or Cu, or a carbon (GC) electrode, for example, Au. The capacity of the container 23 is, but not limited to, a capacity capable of containing a trace amount of body fluid, for example, greater than or equal to the amount of a sample (for example, approximately 0.1 to 1 μL) required for measurement with the biosensor.

The FET 12 can be electrically connected to the sensing unit 11 and is an element for detecting a change resulting from the interaction between the target material and the sensing unit 11. As illustrated in Fig. 1, the FET 12 includes a source electrode 34 and a drain electrode 35 formed on a surface of a semiconductor substrate 31, and a gate-insulating film 33 formed on the source electrode 34 and the drain electrode 35. The FET 12 is preferably an n-channel MOSFET (n-MOS) and may also be a p-channel MOSFET (p-MOS), an n-channel junction FET, a p-channel junction FET, or the like. The metal electrode 32 is formed on the gate-insulating film 33. The metal electrode 32 is electrically connected to the gate electrode 21 on the sensing unit side through the wire 36. The metal electrode 32 can be formed of a metal electrode, such as Au, Ag, or Cu, or a carbon (GC) electrode.

The material of the semiconductor substrate 31 is not particularly limited and can be appropriately selected from known semiconductors, such as Si, GaAs, transparent oxide semiconductors (for example, ITO, IGZO, and IZO), organic semiconductors, and carbon semiconductors (for example, carbon nanotubes, graphene semiconductors, and diamond semiconductors). The measurement sensitivity of the sensor can be higher in the use of a carbon semiconductor than in the use of Si.

The gate-insulating film 33 is provided on the surface of a portion of the semiconductor substrate 31 between the source electrode 34 and the drain electrode 35 (that is, a p-type semiconductor portion in the FET of Fig. 1) and can be formed of an oxide or nitride, such as $SiO_2$, $Si_3N_4$ ($SiN_x$), $Ta_2O_5$, or $Al_2O_3$.

The source electrode 34 and the drain electrode 35 are electrically connected to a power supply 37 and an ammeter 38 and are formed so as to measure a drain current flowing from the source electrode 34 to the drain electrode 35. A change in the charge density on the gate-insulating film 33 causes a change in the drain current. Thus, to keep the drain current constant, the gate voltage must be varied with a change in the charge density on the gate-insulating film 33. The FET 12 measures the change in the gate voltage to electrically measure the change in the charge density on the gate-insulating film 33.

If necessary, a reference electrode 24 may be provided, as illustrated in Fig. 1. The reference electrode 24 is electrically connected to the sensing unit 11, forms a closed circuit together with the source electrode 34 and the drain electrode 35, is an electrode with a reference potential for voltage measurement in the FET, and may be grounded. Practically, the reference electrode 24 is required for voltage measurement in the FET but is not necessarily essential if the target material can be measured by another method.

The typical detection principle of FET biosensors can be found, for example, in Patent Literature 1 or the like.

The present invention will be described more specifically in the following examples, but the present invention is not limited thereto.

## EXAMPLES

### Experiment 1: Experiment on Aminophenyl Thin Film

<<Production Example>>

<1-1. Reagents and Experimental Instruments

4-nitrobenzene tetrafluoroborate (hereinafter referred to as "NBD", 98%) was purchased from Tokyo Chemical Industry Co., Ltd. Acetonitrile (98%), acetone, methanol, ethanol, tetrabutylammonium hexafluorophosphate (95%), potassium hexacyanoferrate (III) (hereinafter referred to as $K_3[Fe(CN)_6]$, 99%), $NaH_2PO_4$, $Na_2HPO_4$, NaOH (1.0 N), HCl (1.0 N), $HNO_3$ (69%), KCl, and Agar (powder) were purchased from FUJIFILM Wako Pure Chemical Corporation. Pure water was prepared with an ultrapure water production system (Ul-pure, Komatsu Electronics Co., Ltd.). A Ag wire (0.6 mm) and a Pt wire (0.7 mm) were purchased from Nilaco. A rod-shaped Au electrode (OD 6 mm; ID 1.6 mm) and alumina slurry (0.05 pm) used as an abrasive for the Au electrode were purchased from BAS and were used to observe the electrochemical characteristics. A plate electrode (0.2 x 1.2 mm, Kyowa International) in which Au/Cr was sputtered

at a film thickness of 100 nm/10 nm on a glass substrate was used to observe physical characteristics, such as the film thickness.

A 100 mM phosphate buffer used in this experiment was prepared by adding $NaH_2PO_4$ and $Na_2HPO_4$ in amounts of 20 mM and 80 mM, respectively, and adjusted to pH 7.4 with NaOH.

A Ag/AgCl electrode was prepared by cutting a Ag wire to a length of approximately 4 cm, immersing the Ag wire in acetone for 20 minutes and in methanol for 20 minutes, thoroughly rinsing the Ag wire with water, and immersing the Ag wire in nitric acid for 30 minutes or more to obtain a uniform silver surface. Electrolysis was performed with an electrochemical analyzer (ALS 618E, BAS) in 0.1 M diluted HCl.

A KCl salt bridge was prepared by dissolving 10 mg of KCl and 1.7 mg of Agar in 50 mL of pure water. After the KCl and Agar were warmed at 100°C with stirring to be entirely dissolved and form a transparent solution, the solution was filled into the tip of a micropipette.

<1-2. Production Method>

(1-2.1 Pretreatment of Electrode and the Like)

An electrochemical analyzer was used for the formation of a NBD thin film and the pretreatment of the thin film. A Ag/AgCl electrode was used as a reference electrode, a Pt wire was used as a counter electrode, and a Au electrode was used as a working electrode. As the pretreatment for the thin film formation, a rod-shaped Au electrode was polished with alumina slurry and was then scanned in a 100 mM phosphate buffer (pH 7.4) by the CV method in the potential range of 0.2 to 1.2 V for 5 cycles at a scanning speed of 100 mV/s until a redox curve characteristic of gold was observed.

The pretreatment for the thin film formation on the plate electrode was performed using acetone and methanol. Ultrasonic cleaning with acetone for 3 minutes was followed by immersion in acetone for 20 minutes. Subsequently, the same treatment was performed using methanol (ultrasonic cleaning for 3 minutes and immersion for 20 minutes).

A CV waveform of the oxidation-reduction of the Au electrode in the phosphate buffer showed that the Au electrode had a surface roughness Ra of 1.368 $\pm$ 0.106 nm and had highly reproducible surface.

(1-2.2 Thin Film Formation on Electrode Using Nitrobenzene Diazonium Salt)

Acetonitrile was used as a solvent to form a NBD thin film. A solution was prepared such that the concentration of tetrabutylammonium hexafluorophosphate as a supporting electrolyte was 100 mM. A blank waveform before NBD modification was obtained in this solution by the CV method, and the NBD solution was then adjusted to 1.0 mM.

The Au electrode was modified with NBD by scanning in the potential range of 0.7 to 0.0 V in the NBD solution, thereby forming a nitrophenyl thin film.

(1-2.3 Reduction of Nitrophenyl Thin Film to Aminophenyl Thin Film and Removal of Unreacted Material)

A reduction treatment of a nitrophenyl thin film to an aminophenyl thin film was electrochemically performed. A nitrophenyl thin film was reduced at -0.9 V for 90 seconds in a water-ethanol solvent (volume ratio: 9:1) containing 0.1 M KCl. A Ag/AgCl electrode was used as a reference electrode, a Pt wire was used as a counter electrode, and the Au electrode after the formation of the nitrophenyl thin film prepared in the previous section was used as a working electrode.

To calculate the density of the film, the nitrophenyl film prepared in the previous section was stirred in methanol for 30 minutes and was then reduced in the water-ethanol solution containing KCl by the CV method in the potential range of 0.0 to 0.9 V for 5 cycles. The water-ethanol solution containing KCl was sufficiently degassed by bubbling with nitrogen gas for 30 minutes or more, and the bubbling was continued during the reduction.

The reduction to the aminophenyl film was followed by ultrasonic cleaning in methanol.

A physisorbed species in the thin film, an unreacted material with a diazo group produced by a side reaction, and the like were removed by the reduction treatment and ultrasonic cleaning.

(1-2.4 Thin Film Formation by Continuous Modification (Comparative Example))

Potential scanning by the CV method of 1-2.2 was continuously performed for 10 cycles, and the treatment of 1-2.3 was finally performed.

The figure in Fig. 2A shows a CV waveform at that time. The reduction current was significantly reduced at the second and subsequent cycles. This is probably because an increased electrode coverage by the thin film prevented NBD from being a radical. The reduction current was little around 10 cycles.

(1-2.5 Thin Film Formation by Iterative Modification (Example))

The treatments of 1-2.2 and 1-2.3 were repeated three times. The treatments were repeated in the same NBD solution, and no NBD was added during the treatments.
The figure in Fig. 2B shows a CV waveform at that time. A very large reduction current flowed also in the second modification, indicating that a larger amount of NBD received a radical from the Au electrode and was allowed to react.
This shows that the potential scanning functions as desorption treatment of a physisorbed species on the Au electrode and that further modification was performed. The density of the aminophenyl thin film was tried to be controlled by repeating this series of electrochemical modification and a reduction process from the nitrophenyl thin film to the aminophenyl thin film (iterative modification). Fig. 3 schematically illustrates this.

<1-3. Evaluation Method>

(1-3.1 Quantitative Evaluation of Aminophenyl Group)

The number of amino groups in the aminophenyl film was calculated from electric charges transferred during the reduction of the nitrophenyl film to the aminophenyl film, and the density thereof was calculated.
The reduction reaction of the nitrophenyl film to the aminophenyl film on the electrode can be represented by the following formulae:
[Chem. 3]

$$\text{Au-Ar-NO}_2 + 4\text{e-} + 4\text{H}^+ \rightarrow \text{Au-Ar-NHOH} + \text{H}_2\text{O} \quad (1)$$

$$\text{Au-Ar-NHOH} + 2\text{e-} + 2\text{H}^+ \rightarrow \text{Au-Ar-NH}_2 + \text{H}_2\text{O} \quad (2)$$

$$\text{Au-Ar-NHOH} \Leftrightarrow \text{Au-Ar-NO} + 2\text{e-} + 2\text{H}^+ \quad (3)$$

Fig. 4 shows CV waveforms in the reduction of the nitrophenyl film of Comparative Example. The first cycle has a very large reduction peak around -0.8 V. The electric current decreases with the cycle number and decays to almost constant levels in fourth to fifth cycles. This change in electric current shows that the two formulae (1) and (2) are reduction currents contributing to the reduction at -0.8 V.
An oxidation peak around -0.2 V is large at the first cycle but decays significantly after the first cycle. A peak around -0.25 V in the second cycle immediately after the first cycle is not observed in the first cycle, and no clear peak is observed in the subsequent cycles. This indicates that Au-Ar-NHOH formed in the first cycle is oxidized to Au-Ar-NO, and the reduction peak at -0.25 V and the oxidation peak at -0.2 V show the redox reaction (3) in the second cycle.
The electric charges used for the reduction are calculated from these reactions. The fourth and fifth cycles had a very small change, and it is therefore assumed that modified nitrophenyl was entirely reduced to aminophenyl in the fifth cycle. Thus, the CV in the fifth cycle is treated as a blank, and an electric current flowing as the difference thereof is described below.
Although a molecule modified by a diazo bond of unreduced diazonium near the Au electrode is also desorbed from the film due to the reduction of the diazo bond, this was not considered in the present calculation, and the surface density $\Gamma_i$ of a functional group reduced to the amino group at the i-th cycle (i = 1 to 4) was calculated on the assumption that only the six electron reaction of the formula (3) occurred. The calculation formula is as follows:

[Math. 1]

$$\Gamma_i = \frac{Qi - Q5}{6 \cdot F \cdot A}$$

wherein Qi denotes the total amount of electric charges flowing in the i-th cycle, F denotes the Faraday constant (9.65 x $10^4$ C/mol), and A denotes the electrode area (= 0.0201 $cm^2$).

(1-3.2 Evaluation of Insulating Properties of Thin Film: Measurement of Alternating-Current Impedance)

The alternating-current impedance was measured in the same manner as described in Non-Patent Literature

2 or the like to calculate the charge transfer resistance ($R_{ct}$).

An aminophenyl film thus prepared was subjected to cyclic voltammetry and alternating-current impedance measurement using an Fe probe. The measurement was performed in a 100 mM phosphate buffer (pH 7.4) containing 10 mM $K_3[Fe(CN)_6]$.

In CV, after application of 0.5 V for 10 seconds, scanning was performed in the range of 0.5 to -0.3 V at a scanning speed of 100 mV for approximately 5 cycles until the waveform was stabilized.

In the alternating-current impedance measurement, the initial potential was set at 0.215 V by reading the redox potential of a $[Fe(CN)_6]^{4-}/[Fe(CN)_6]^{3-}$ probe in unmodified gold from CV. The amplitude of the modulation potential was 10 mV, and the measurement frequency range was $10^5$ to 1 Hz.

(1-3.3 Evaluation of Probe Ion Permeability)

CV with a probe ion ($[Fe(CN)_6]^{3-}$) was performed to examine the molecular permeability of a film in each state. A comparison was made between three electrodes: a nitrophenyl film electrode immediately after preparation, an electrode prepared by washing a prepared nitrophenyl (NP) film with methanol with stirring for 30 minutes, and an aminophenyl (AP) film after reduction.

<1-4. Results>

(1-4.1 Quantitative Evaluation of Aminophenyl Group)

Table 1 shows the results of the quantitative evaluation of the aminophenyl group in Comparative Example and Example. These results are also shown in Fig. 5. The unit in the table is molecules/nm$^2$.

[Table 1]

| | Number of Cycles Number of Iteration | $\sum_i \Gamma i$ | Γ i | | | |
|---|---|---|---|---|---|---|
| | | | i = 1 | i = 2 | i = 3 | i = 4 |
| Comparative Example | 1 Cycle | 4.87 | 4.16 | 0.55 | 0.15 | 0.04 |
| | 2 cycle | 7.82 ± 0.46 | 6.43 ± 0.29 | 0.91 ± 0.08 | 0.37 ± 0.08 | 0.10 ± 0.004 |
| | 10 Cycle | 8.96 ± 2.26 | 7.02 ± 1.58 | 0.97 ± 0.24 | 0.55 ± 0.18 | 0.41 ± 0.27 |
| Example | 1 Time | 4.87 | 4.16 | 0.55 | 0.15 | 0.04 |
| | 2 Time | 9.14 ± 0.83 | 8.37 ± 0.21 | 0.59 ± 0.54 | 0.12 ± 0.11 | 0.06 ± 0.02 |
| | 3 Time | 8.74 ± 0.62 | 7.05 ± 0.47 | 0.91 ± 0.14 | 0.32 ± 0.08 | 0.17 ± 0.07 |

In continuous modification of Comparative Example 1, the nitro groups were mostly reduced to amino groups in the first cycle. The number of amino groups increased by the continuous modification, but the increase tended to decrease as the number of modifications increased. It is thought that the formation of the thin film on the electrode was limited due to inhibition by a molecule of a physisorbed species or the like.

The total Γi (= 14.01 molecules/nm$^2$) of the first iterative modification and the second iterative modification in iterative modification of Example 1 was larger than the number of molecules Γi (= 8.96 molecules/nm$^2$) of 10 cycles of continuous modification of Comparative Example 1, and a denser aminophenyl film could be produced in the iterative modification of Example 1.

Paying attention to the difference in the modification amount between the first modification and the second modification in the iterative modification of Example 1, it is thought that, in the case of modification with a solution of the same concentration on a Au electrode, the modification amount should decrease in the subsequent modification because modification to the electrode is inhibited by the previously modified molecule, but in the present results the modification amount is larger in the second and third modifications than in the first modification. This is considered to be related to the electron-donating ability of the amino group. In reductive modification with the same diazonium salt, a molecule with higher electron nucleophilicity has lower reactivity with a radical and forms a thin film, while a molecule with higher electron-donating ability has higher reactivity with a radical and forms a relatively thick film. In the aminophenyl film in this case, an ortho carbon of the benzene ring is positively polarized due to the electron-donating ability of the amino

group. Thus, it is thought that NBD with a radical formed by reduction of the diazonium salt can be bonded to the aminophenyl film in preference to the Au electrode.

(1-4.2 Evaluation of Insulating Properties of Thin Film: Measurement of Alternating-Current Impedance)

Fig. 6 shows a Nyquist plot of alternating-current impedance measurement in 0 to 3 iterative modifications. Table 2 shows the calculated charge transfer resistance ($R_{ct}$).

[Table 2]

| Number of Iteration | $R_{ct}$ [$\Omega \cdot cm^2$] |
|---|---|
| 0 Time (Bare Au) | 1.55 |
| 1 Time(AP(1 cycle)) | 19.2 ± 8.03 |
| 2 Time (AP (2 cycle)) | 66.9 ± 17.0 |
| 3 Time (AP(3 cycle)) | 2100 ± 19.0 |

As is clear from this result, the charge transfer resistance increased exponentially with the number of iterations.

The formation of a film with a higher density reduces molecular permeability at the solution/electrode interface. Thus, depending on the purpose of a sensor to be designed, the number of iterations in the production of a thin film can be changed to form sufficient voids in the film for allowing a material to be detected to permeate the thin film.

(1-4.3 Evaluation of Probe Ion Permeability)

Fig. 7 shows the evaluation results of probe ion permeability. Although a nitrophenyl (NP) film immediately after its preparation was highly insulating, the electrode stirred in methanol for 30 minutes lost its insulating properties, and a redox peak of $[Fe (CN)_6]^{3-/4-}$ was detected.

This is similar to a CV waveform of an aminophenyl (AP) film after reduction, showing that the $[Fe(CN)_6]^{3-}$ permeability was not significantly different between the nitrophenyl film and the aminophenyl film after sufficient washing with methanol. This shows physical adsorption of NBD, which is easily desorbed by stirring in methanol, at the interface after or during the preparation of the nitrophenyl film.

It is thought that inhibition by a modification molecule in the continuous modification of Comparative Example 1 can be two types of inhibition: inhibition by a molecule chemically bonded to the Au electrode and inhibition by a physisorbed molecule on an electrode surface. It was found that the inhibition by the latter was very large even after 10 cycles of modification. It can be said that a denser aminophenyl film could be produced by the method of Example 1 due to a smaller influence of the second inhibition.

Experiment 2: Experiment on Phenylboronic Acid (PBA) Thin Film

<2-1. Reagents and Experimental Instruments>

4-aminophenylboronic acid pinacolate was purchased from Sigma Aldrich. Sodium nitrite, sodium periodate, and tetrahydrofuran were purchased from FUJIFILM Wako Pure Chemical Corporation, and the other reagents and buffer were those used in Experiment 1.

<2-2. Production Method>

(2-2.1 Pretreatment of Electrode and the Like)

An electrochemical analyzer was used for 4-aminophenylboronic acid pinacolate modification and pretreatment therefore. A Ag/AgCl electrode was used as a reference electrode, a Pt wire was used as a counter electrode, and a Au electrode was used as a working electrode.

A rod-shaped Au electrode was polished with alumina slurry as a pretreatment for modification. Subsequently, to desorb a molecule adsorbed on the gold interface, scanning was performed in a 0.5 M aqueous sodium hydroxide by the CV method in the potential range of -1.6 to 0.7 V for 10 cycles at a scanning speed of 100 mV/s. Subsequently, after washing in ethanol with stirring for 30 minutes or more, CV was performed in a 0.5 M aqueous sulfuric acid in the range of 0.2 to 1.5 V for approximately 8 cycles until a redox potential diagram characteristic of gold was observed. The

washing was followed by immersion in 0.5 M hydrochloric acid used for modification. Acetone and methanol were used for the pretreatment for modification on a plate electrode in the same manner as in the NBD modification pretreatment of Experiment 1.

(2-2.2 Diazotization of Aminophenyl Boronic Acid)

Before the formation of a thin film, first, 1.0 mM of 4-aminophenylboronic acid pinacolate and 2.0 mM of sodium nitrite were added in a cold 0.5 M hydrochloric acid solution and were stirred for 10 minutes until the color of the solution changed sufficiently to yellow to diazotize the amino group.

The diazotization reaction of the amino group is performed through the formula (4):

[Chem. 4]

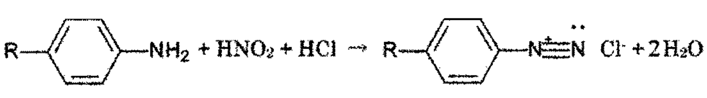

(4)

(2-2.3 Formation of PBA Thin Film)

The diazonium salt was reduced by the CV method in the range of 0.6 to -0.2 V at a scanning speed of 50 mV/s. To more densely form a thin film, after modification for 5 cycles, the CV method was performed in the potential range of 0.0 to 0.9 V for 5 cycles in the same water-ethanol solution containing KCl as in Experiment 1 to perform desorption treatment of a physisorbed species on the electrode surface, and the modification was then performed 5 cycles again. This operation was repeated.

(2-2.4 Elimination of Pinacol Ester)

In this experiment, to prevent the formation of a cyclic trimer anhydride by a reaction of boronic acid itself, a PBA thin film was prepared using 4-aminophenylboronic acid pinacolate during the thin film formation. Thus, to function boronic acid as a diol receptor, pinacol elimination treatment was performed after the film formation of 2.3.

The pinacol elimination treatment was performed in a tetrahydrofuran-water solvent (volume ratio: 1:4) containing 50 mM of sodium periodate with stirring for 18 hours or more. As a comparison of pinacol non-elimination, a tetrahydrofuran-water solvent without sodium periodate stirred for 18 hours or more was used as a control.

<2-3. Results>

(2-3.1 Densification of PBA Thin Film)

Fig. 8 is a modification CV waveform figure of phenylboronic acid pinacolate. In the first cycle of the first modification, there are large reduction peaks near 0.26 V and -0.01 V, which are not present in the blank, indicating that these peaks are the reduction peaks of phenylboronic acid. These reduction peaks decayed with the cycle number.

Fig. 9 shows the second, fourth, and eighth modification waveform figures in iterative modification. In this iterative modification, the reduction current in the first cycle of the n-th iteration is higher than the reduction current in the fifth cycle of modification of the (n-1)-th iteration. This shows that the potential scanning is also effective for the desorption of a physisorbed species in the preparation of a phenylboronic acid film.

(2-3.2 Electrochemical Characteristics of PBA Thin Film)

Fig. 10 shows the insulating properties of this thin film examined by CV using a $[Fe\ (CN)_6]^{3-/4-}$ probe.

The redox current of the $[Fe(CN)_6]^{3-/4-}$ probe decreases with the number of iterations. This means that repeating the thin film formation (modification) and the desorption of a physisorbed species increased the denseness of the thin film and thereby improved the insulating properties. This shows that the denseness control of phenylboronic acid pinacolate is also possible in the same manner as in the aminophenyl film.

(2-3.3 Change in Characteristics of PBA Thin Film Due to Pinacol Elimination)

A change in the conductivity of a film due to pinacol elimination treatment was examined. Fig. 11 shows a comparison of Nyquist plots of the alternating-current impedance of a pinacol-eliminated PBA thin film electrode and a pinacol-uneliminated PBA thin film electrode among films continuously modified with phenylboronic acid pinacolate for two cycles.

Elimination of the pinacol ester greatly reduced the charge transfer resistance. This suggests that a large decrease in the density of the film greatly increased the $[Fe(CN)_6]^{3-/4-}$ probe permeability. This shows that the $[Fe(CN)_6]^{3-/4-}$ probe permeability of the phenylboronic acid pinacolate film depends significantly on the steric hindrance effect of the pinacol. This suggests that the elimination of pinacol may have a significant influence in the phenylboronic acid modification.

Experiment 3: Experiment on Phenylphosphorylcholine (PPC) Thin Film

<3-1. Reagents and Experimental Instruments>

4-aminophenylphosphorylcholine (PPC) was purchased from Cosmo Bio Co., Ltd., and human serum albumin (HSA) was purchased from FUJIFILM Wako Pure Chemical Corporation. The other reagents and buffer were those used in Experiment 1.

<3-2. Production Method>

(3-2.1 Electrode Pretreatment and Diazotization of 4-aminophenylphosphorylcholine)

The same electrode pretreatment as in Experiment 2 or the like was performed. Before a thin film was formed, 1.0 mM PPC and 2.0 mM sodium nitrite were added in a cold 0.5 M hydrochloric acid solution and were stirred for 10 minutes to diazotize the amino group of 4-aminophenylphosphorylcholine.

(3-2.2 Formation of PPC Thin Film)

CV iterative modification was performed to observe the influence of thin film formation and physisorbed species desorption on an electrode. After 10 cycles of modification, a surface physisorbed species was desorbed by the CV method in the water-ethanol solution containing KCl as in Experiment 2. The modification was then repeated.

To examine the characteristics of a thin film, the film was modified by reduction to increase the denseness by fixing the electric potential at the reduction potential (= -0.35 V) of a PPC diazonium salt described later for 3 minutes.

For desorption of a surface physisorbed species, ultrasonic cleaning was performed with methanol for 3 minutes and with pure water for 1 minute. Acetone and methanol were used for the pretreatment for modification on a plate electrode as in Experiments 1 and 2.

<3-3. Evaluation Method>

(3-3.1 Measurement of Contact Angle of PPC Thin Film)

To confirm the formation of a PPC thin film on the surface of a Au electrode, the contact angle was measured. Pure water was used as a solvent, and a contact angle measuring instrument (DSA 25, KRUeSS GmbH) was used for measurement. In this measurement, a plate electrode was used after PPC modification by CV at a reduction peak -0.35 V of diazonium salt reductive modification for 3 minutes and iterative modification 5 times in which desorption of a surface physisorbed species by ultrasonic cleaning was repeated.

(3-3.2 Measurement of Alternating-Current Impedance of PPC Thin Film during Immersion in HSA)

A film prepared by iterative modification was immersed in a HSA solution to investigate the anti-fouling effect of a PC group by alternating-current impedance measurement using a $[Fe(CN)_6]^{3-/4-}$ probe. The measurement was performed under the same conditions as in Experiment 1.

The electrodes used in the test were an unmodified Au electrode, a Au electrode with an aminophenyl (AP) thin film, and a Au electrode with a PPC thin film, and the amount of modification was controlled for comparison. More specifically, the Au electrode with the AP thin film was subjected to the iterative modification of Experiment 1 once or twice. In the Au electrode with PPC, a comparison was made between 3-minute modification by CV at a reduction peak

-0.35 V of diazonium salt reductive modification, one or five iterative modifications by repeating ultrasonic cleaning, and only continuous modification for 30 min.

The measurement was followed by immersion in a 100 mM phosphate buffer (pH 7.4) containing 0.1 mg/mL, 1.0 mg/mL, and 10 mg/mL of HSA for 10 minutes, light washing in pure water, and then immersion in a solution used for CV and alternating-current impedance measurement for 10 minutes, and then the measurement was performed.

(3-3.3 FET Response of PPC Thin Film to Biomolecule)

To sense a biomolecule using a body fluid, it is necessary to reduce the influence of a protein in the body fluid adhered to an electrode and reduce an electrical signal of the protein. Thus, HSA was added to a PPC film thus formed to examine the FET response of the Au electrode.

Unmodified gold and two types of PPC thin films (a 3-minute continuously modified PPC thin film (Comparative Example) and an iteratively modified PPC thin film subjected to 3-minute modification and ultrasonic cleaning repeated 5 times (Example)) were used.

More specifically, an n-channel junction FET (K246-Y9A, Toshiba) gate electrode was coupled to a modified Au electrode, and a gate voltage was applied through a KCl salt bridge in the Ag/AgCl electrode.

The gate potential was recorded with an FET real-time monitoring system (PROVIGATE Inc.) in real time with the addition of a target.

The gate potential was measured using a source follower circuit (Fig. 12) to equalize the change in the source potential with the change in the gate potential. A gate potential VG of 2.5 V and a drain voltage VD of 4.95 V were applied during the measurement.

The modified Au electrode was immersed in 23 mL of a 100 mM phosphate buffer (pH 7.4) in a glass cell, and the gate potential was measured in a stirring environment. To stabilize the state of the interface, after application of a gate potential and standing for approximately 2 hours, the measurement was started when the surface potential was stabilized.

The concentration of HSA added ranged from 1 pg/mL to 100 mg/mL, and the amount of addition was adjusted so that the concentration of the solution in which the electrode was immersed after the addition ranged from 10 ng/mL to 1 mg/mL.

To examine how much the effect of reducing the adsorption of a protein to the electrode surface influences the FET response, norepinephrine-added FET measurement was performed in a HSA environment. FET measurement was performed using a 100 mM phosphate buffer (pH 7.4) containing 1.0 mg/mL of HSA with the addition of norepinephrine.

<3-4. Results>

(3-4.1 CV Waveform during PPC Thin Film Formation)

Figs. 13 and 14 show CV waveforms in the formation of a PPC thin film. Two reduction peaks were observed around 0.05 V and -0.36 V, which were not observed in the blank. The electric potential for modification at a fixed electric potential was -0.35 V of the second peak.

Fig. 13 shows CV waveforms of 20 cycles of continuous modification. From the fact that the modification amount in the second cycle is not greatly reduced as compared with the modification of NBD or phenylboronic acid pinacolate, and the fact that the reduction potential of a diazonium salt derived from phenylphosphorylcholine is lower than the reduction potentials of other diazonium salts (NBD: 0.48 V, 0.25 V; phenylboronic acid pinacolate: 0.26 V, -0.01 V), it is understood that a precursor of the PPC thin film has lower reactivity than the other diazonium salts.

Fig. 14 shows the changes of modification waveforms in which a surface physisorbed species was desorbed after the modification. In a process of 10 cycles of modification and 5 cycles of desorption CV of a surface physisorbed species, the second, fifth, and tenth modification waveforms were shown from the left. Also in the modification of phenylphosphorylcholine, in the same manner as in NBD and phenylboronic acid pinacolate, it was confirmed that the modification amount on the Au electrode could be controlled by the desorption of a physisorbed species.

(3-4.2 Measurement of Contact Angle of PPC Thin Film)

Fig. 15 shows the measurement results of the contact angle. In spite of high hydrophobicity of a Au electrode, the electrode with a PPC thin film had a very low contact angle and very high hydrophilicity. This is due to the very high hydrophilicity of the PC group of PPC, and the physical characteristics indicate PPC modification on the electrode.

(3-4.3 Measurement of Alternating-Current Impedance of PPC Thin Film during Immersion in HSA)

Fig. 16 shows charge transfer resistance ($R_{ct}$) calculated from the results of alternating-current impedance measurement. Before a PPC film was immersed in a HSA solution, the $R_{ct}$ of an electrode modified for 3 minutes was $50.4 \pm 15.5\ \Omega \cdot cm^2$, and the $R_{ct}$ of an electrode modified for 30 minutes was $35.9\ \Omega \cdot cm^2$, showing no significant difference therebetween. However, the $R_{ct}$ of a film modified for 3 minutes five times was $212 \pm 97.7\ \Omega \cdot cm^2$, which is much higher than those of the above PPC films.

This shows that, also in a molecule with low reactivity, such as PPC, as in a film prepared by reductive modification with another diazonium salt, desorption of a physisorbed species on the surface, rather than the modification time, is important in closely controlling the modification amount of the film.

The addition of HSA increased the $R_{ct}$ of an unmodified Au electrode and an AP thin film electrode. This is probably because non-specific adsorption of HSA on each electrode surface significantly reduced molecular ($[Fe(CN)_6]^{3-/4-}$) permeability at the solution/electrode interface.

One reason for the larger increase in the $R_{ct}$ of the AP film is the surface charge. It is thought that, at pH 7.4, HSA is negatively charged, and the amino group is positively charged. Thus, it is thought that the protein was adsorbed due to electrostatic interaction between the protein and the aminophenyl group at the interface.

On the other hand, the increase in $R_{ct}$ was smaller in the PPC thin film electrode than in the other electrodes, regardless of the HSA concentration. In particular, a PPC thin film with a higher density subjected to five iterative modifications had a very high suppressive effect.

r (= $R_{ct,\ HSA1.0}/R_{ct,\ HSA0.0}$) of $R_{ct,\ HSA1.0}$ of a PPC film subjected to five iterative modifications after immersion in a 1 mg/mL HSA solution to $R_{ct,\ HSA0.0}$ before immersion in the HSA solution was 1.1, which was much lower than 263.6 of the Au electrode and 44.4 of an AP film subjected to two iterative modifications. The PPC modification could greatly reduce the influence of a protein on an electrode, that is, the influence of another molecule on the permeability of a film due to non-specific adsorption to the surface.

Although this value on the Au electrode is comparable to that of a highly insulating film of SAM utilizing a thiol in Non-patent Literature 3, due to a multilayer film formed by reduction of a diazonium salt, molecular permeability is also provided. This shows that PPC can be expected to be used as a molecule that can be expected to have an anti-fouling effect at a nanofilter interface.

(3-4.4 FET Response of PPC Thin Film to Biomolecule)

Fig. 17 shows the results of the FET response of a PPC thin film to a biomolecule.

The PPC thin film is less responsive to HSA than unmodified gold. The suppression was approximately 0.6 times in the continuously modified PPC thin film of Comparative Example and approximately 0.3 times in the iteratively modified PPC thin film of Example. It was also found that the non-specific adsorption of HSA to the electrode surface can be reduced in a denser film.

Although an electrical signal due to HSA itself was reduced by PPC modification, the degree of reduction did not correlate with the denseness of the film. These suggested that the formation of a dense PPC thin film can reduce the influence on the $[Fe(GN)_6]^{3-/4-}$ probe but cannot reduce a signal due to HSA itself.

Fig. 18 shows the results of norepinephrine-added FET measurement in a HSA environment performed to examine how much the effect of reducing the adsorption of a protein to the electrode surface influences the FET response.

First, the unmodified Au electrode had a very large response in the absence of HSA, whereas even the response to the same concentration of norepinephrine was not more than half thereof in the HSA environment. This is considered to be the result of non-specific adsorption of HSA on the electrode surface reducing the transfer of norepinephrine to the electrode surface.

The response of PPC was lower than the response of the unmodified Au electrode in the absence of HSA but was higher than the norepinephrine response of the unmodified Au electrode in the presence of HSA, despite the measurement of norepinephrine in the same HSA environment. This can be said to be the result of reduced adsorption of HSA on the electrode surface due to PPC modification on the Au electrode and is consistent with the result of alternating-current impedance measurement using the $[Fe\ (CN)_6]^{3-/4-}$ probe.

These results demonstrated the anti-fouling effect of PPC modification and an actual successful example of biomolecular sensing.

Experiment 4: Experiment on PBA/PPC Mixed Thin Film

<4-1. Reagents and Experimental Instruments>

The reagents and experimental instruments described in Experiments 1 to 3 were used.

<4-2. Production Method>

A PPC/PBA mixed thin film was prepared. First, as in Experiment 2, phenylboronic acid pinacolate modification was performed by CV for two cycles, and pinacol elimination treatment was performed to remove the protection of the boronic acid. A PBA thin film thus prepared was subjected to PPC modification by fixing the electric potential to -0.35 V (vs. Ag/AgCl) for 3 minutes in the same manner as in Experiment 3 and was then washed with methanol and/or water. This operation was repeated five times to prepare a PPC/PBA mixed thin film.

<4-3. Evaluation Method>

(4-3.1 Alternating-Current Impedance Measurement)

The same $[Fe(CN)_6]^{3-/4-}$ probe as in the above experiment was used to perform CV and alternating-current impedance measurement. The measurement was performed under the same conditions as those described above. To examine the anti-fouling effect, the measurement of the change in impedance due to the HSA immersion performed in Experiment 3 was performed on the PBA thin film before the PPC modification and on the PPC/PBA mixed thin film after the PPC modification. The charge transfer resistance $R_{ct}$ was determined from these results.

(4-3.2 Norepinephrine FET Response)

Norepinephrine was added under the same conditions as in Experiment 3, and the FET response of the PPC/PBA mixed thin film and the like was measured. For the measurement, 100 nM to 316 mM norepinephrine was added every 5 minutes, and the concentration of the norepinephrine solution to be reacted with the electrode was prepared by $10^{1/2}$-fold every 5 minutes in the range of 1 nM to 3.16 mM.

<4-4. Results>

(4-4.1 AC Impedance Measurement)

Fig. 19 shows the results of the charge transfer resistance $R_{ct}$ determined from the alternating-current impedance measurement.

A comparison between the $R_{ct}$ of the PBA thin film before the PPC modification and the $R_{ct}$ of the PPC/PBA mixed thin film in the absence of HSA shows that the $R_{ct}$ of the PPC/PBA mixed thin film is higher than the $R_{ct}$ of the PBA thin film. This result shows that $Fe[(CN)_6]^{3-/4-}$ probe permeability is lower in the PPC/PBA mixed thin film than in PBA, that is, the film is more physically modified than the PBA single thin film.

In addition, when attention was paid to the change in $R_{ct}$ during HSA immersion, the results showed that the HSA immersion significantly changed the $R_{ct}$ of the PBA thin film, whereas the $R_{ct}$ of the PPC/PBA mixed thin film did not change almost regardless of the concentration of HSA. These show that the mixed thin film also has the anti-fouling effect of PPC described in Experiment 3.

In the related art of increasing the functionality of a thin film by sequential formation (modification) of layers of a precursor of a diazonium salt, from the perspective of controlling the density of a constituent molecule of the thin film, the modification is performed after the order of modification is determined from the level of the diazonium salt reduction potential at the time of radical generation. Thus, a technique of performing PPC modification before modification with another precursor has been used to control a constituent material of a thin film.

However, when considering the design of a nanofilter interface, to maximize the anti-fouling effect of PPC, PPC should be present on the outermost surface of the thin film, and the PPC modification (layer formation) should be performed last. It is highly advantageous that this modification order limitation due to the difference in reduction potential could be overcome by iterative modification with desorption treatment of a surface physisorbed species, such as an unreacted material.

The results of Figs. 16 and 19 are shown side by side in Fig. 20.

A comparison between a PPC thin film subjected to continuous modification for 30 min and the same PPC thin film subjected to iterative modification for 5 times including electrochemical modification for 3 min each immersed in a solution without HSA (the influence of non-specific adsorption was not considered) showed that the latter thin film had a higher $R_{ct}$ and a higher density. This is larger than the $R_{ct}$ of a PPC thin film reported in Non-patent Literature 3, and it can be said that the present modification method widened the density control range of a PPC thin film.

Furthermore, it is thought that the addition of HSA significantly reduced molecular permeability at a solution/electrode interface, that is, increased the transfer resistance of $Fe[(CN)_6]^{3-/4-}$, due to nonspecific adsorption of HSA on the surface of an electrode, such as an unmodified Au electrode, an AP thin film electrode, or a PBA thin film electrode.

On the other hand, the increase in $R_{ct}$ is smaller in the PPC thin film electrode than in the other electrodes, regardless of the HSA concentration. In particular, a PPC thin film with a higher density had a higher suppressive effect (PPC 3 min x 5: it took 3 minutes for each PPC modification in five iterative modifications with PPC). Furthermore, the PPC/PBA mixed thin film also had an anti-fouling effect, which could not be achieved in the PBA thin film (the effect of PPC).

(4-4.2 Norepinephrine FET Response)

Fig. 21 shows the results of the FET response of the PPC/PBA mixed thin film to norepinephrine. It was found that, even after PPC modification, the thin film still has norepinephrine permeability and allows biomolecular sensing as in unmodified gold.

Even another diazonium thin film (PBA thin film) modified with PPC with low reactivity could retain norepinephrine permeability and could be measured by FET.

Although several embodiments and examples of the present disclosure have been described above, these embodiments and examples are illustrative of the present disclosure. For example, each embodiment has been described in detail for the purpose of explaining the present disclosure in an easy-to-understand manner, and the dimensions, structure, material, and circuit may be added or changed as necessary. It should be noted that an embodiment in which one or more of the features of the present disclosure described above are combined is also within the scope of the present disclosure. The claims are intended to cover numerous variations of the embodiments without departing from the technical idea of the present disclosure. Accordingly, the embodiments and examples disclosed herein are presented by way of illustration and should not be considered as limiting the scope of the present disclosure.

Reference Signs List

10 biosensor
11 sensing unit
12 field-effect transistor (FET)
21 gate electrode
22 thin layer
23 container
24 reference electrode
32 metal electrode
33 gate-insulating film
34 source electrode
35 drain electrode
36 metal wire (wiring)
37 power supply
38 ammeter

## Claims

1. A method for producing a thin film, comprising the steps (a) to (e) in this order:

   (a) providing an electrically conductive substrate;
   (b) using a first precursor to form a first layer on a surface of the electrically conductive substrate;
   (c) removing at least part of an unreacted material from the first layer;
   (d) electrochemically bonding a second precursor onto a surface of the electrically conductive substrate or to the first layer to form a second layer; and
   (e) repeating the steps (c) and (d).

2. The production method according to Claim 1, wherein the step (e) is repeated two or more times.

3. The production method according to Claim 1 or 2, wherein the step (c) is electrochemically performed.

4. The production method according to Claim 1 or 2, wherein the step (c) is performed by an ultrasonic cleaning.

5. The production method according to any one of Claims 1 to 4, wherein the first and second precursors are the same material.

6. The production method according to any one of Claims 1 to 5, wherein the first and second precursors are each individually selected from diazo aromatic compounds.

7. The production method according to any one of Claims 1 to 6, wherein the first and second precursors are nitrophenyl diazonium, and the first and second layers are converted into an aminophenyl group by an electrochemical reduction treatment.

8. The production method according to any one of Claims 1 to 7, wherein the electrically conductive substrate is an electrode of an electrochemical biosensor, and the thin film is formed on a surface of the electrode.

9. A method for producing an electrochemical biosensor including an electrode, the method comprising: forming the thin film on a surface of the electrode by the method according to Claim 8.

10. The method for producing an electrochemical biosensor according to Claim 9, further comprising a field-effect transistor including the electrode, or a field-effect transistor including a gate electrode coupled to the electrode.

11. A thin film comprising:

a layer with an aminophenyl group,
wherein the aminophenyl group has a denseness of 10 molecules/$nm^2$ or more.

12. The thin film according to Claim 11, wherein the thin film has a thickness of 10 nm or less.

13. The thin film according to Claim 11 or 12, wherein the thin film has a charge transfer resistance ($R_{ct}$) of 50 $\Omega \cdot cm^2$ or more.

14. An electrochemical biosensor comprising the thin film according to any one of Claims 11 to 13 on a surface of an electrode.

15. The electrochemical biosensor according to Claim 14, further comprising a field-effect transistor including the electrode, or a field-effect transistor including a gate electrode coupled to the electrode.

FIG. 1

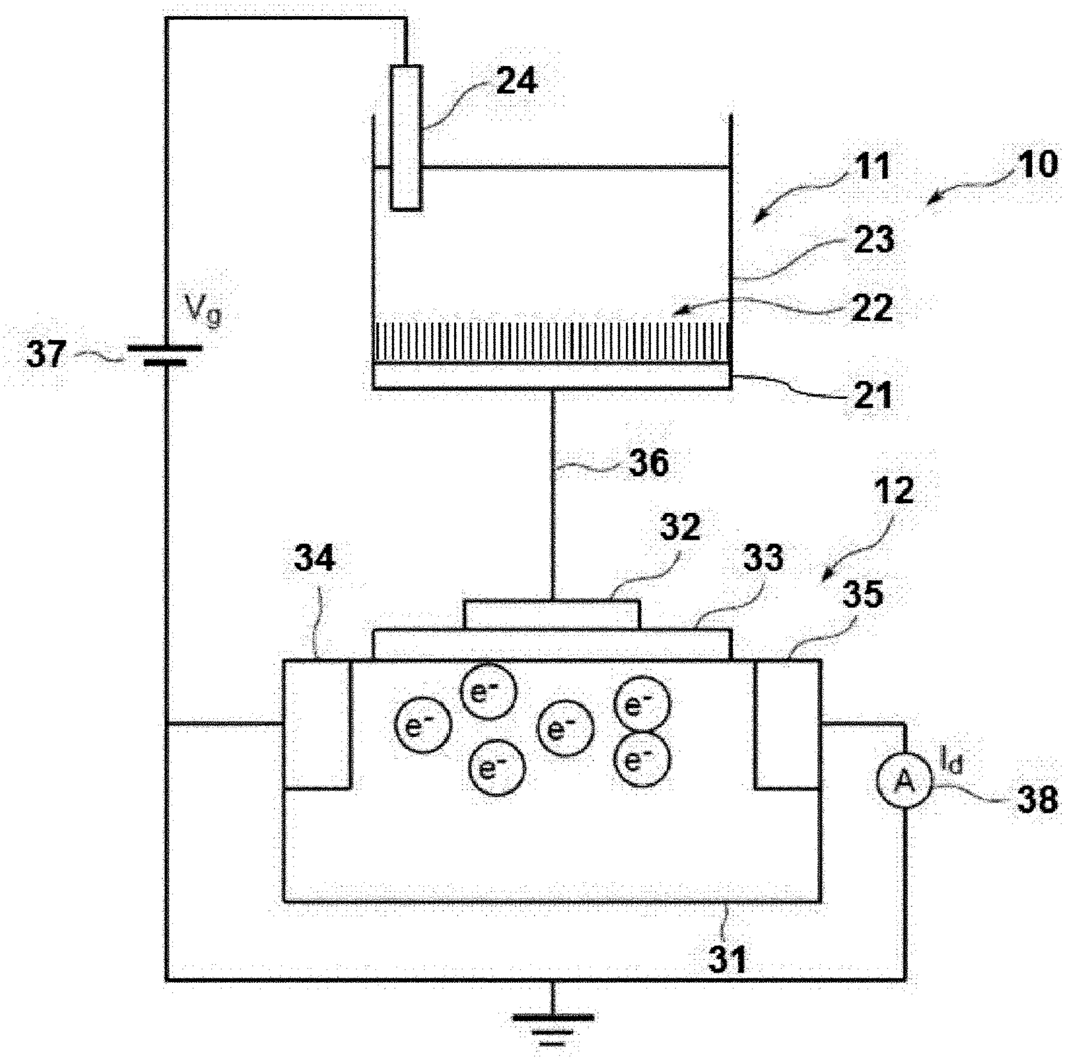

*FIG.2*

(B)

(A)

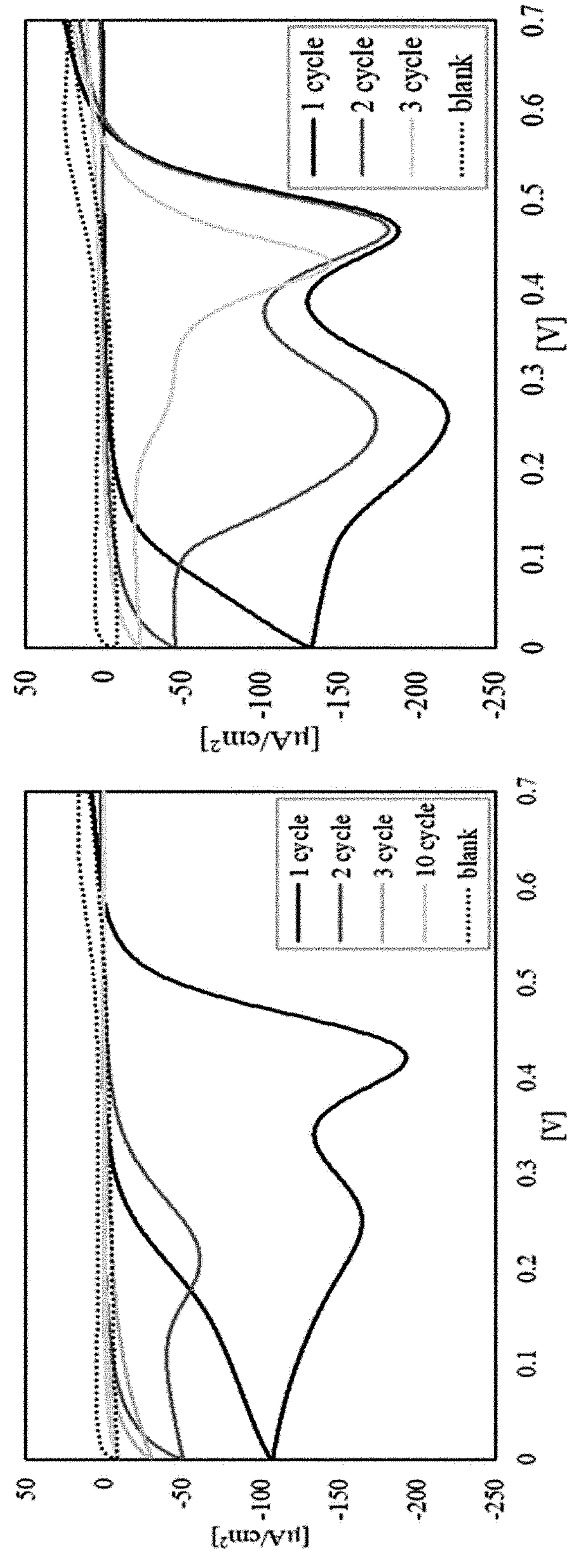
1 cycle
2 cycle
3 cycle
blank
1 cycle
2 cycle
3 cycle
10 cycle
blank
[μA/cm²]
[V]
50
0
-50
-100
-150
-200
-250
0
0.1
0.2
0.3
0.4
0.5
0.6
0.7

FIG.3

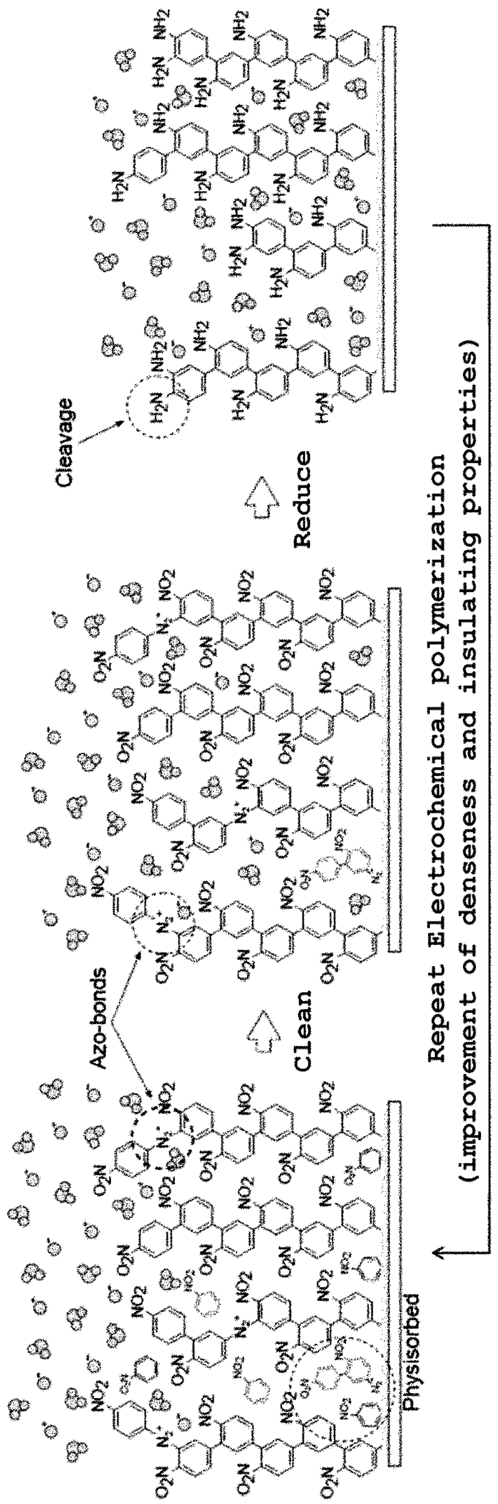
Physisorbed
Azo-bonds
Clean
Reduce
Cleavage
Repeat Electrochemical polymerization
(improvement of denseness and insulating properties)

FIG.4

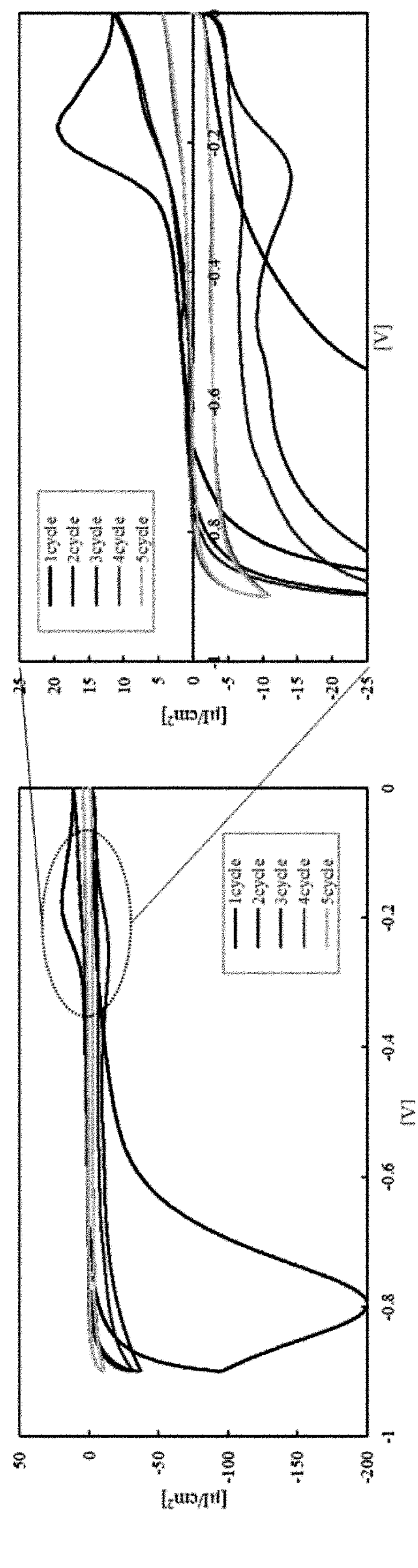

FIG.5

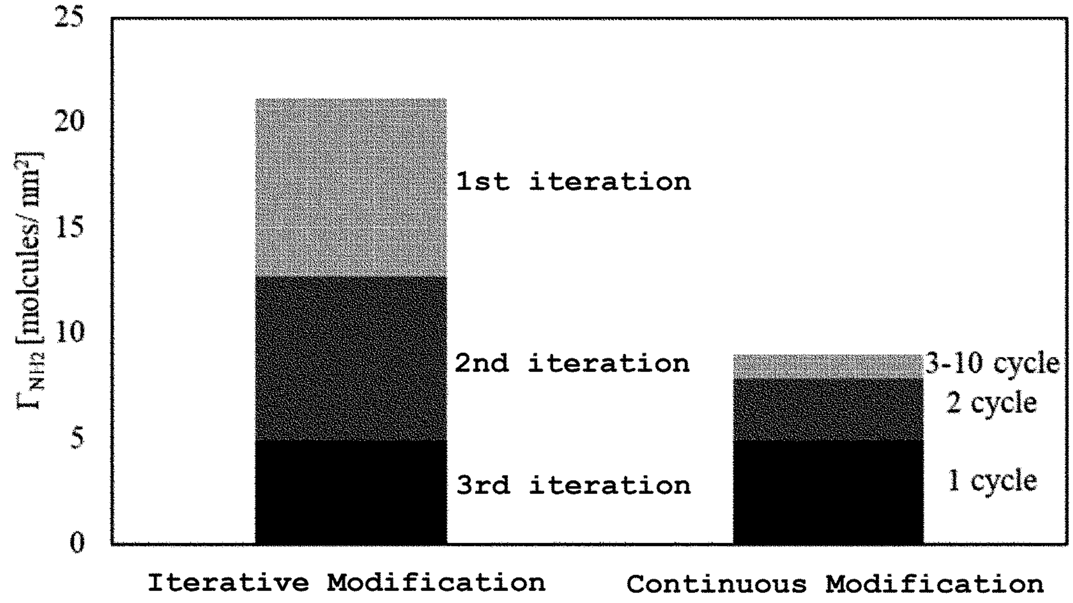
25
20
15
10
5
0
$\Gamma_{NH2}$ [molcules/ nm$^2$]
1st iteration
2nd iteration
3rd iteration
3-10 cycle
2 cycle
1 cycle
Iterative Modification
Continuous Modification

FIG.6

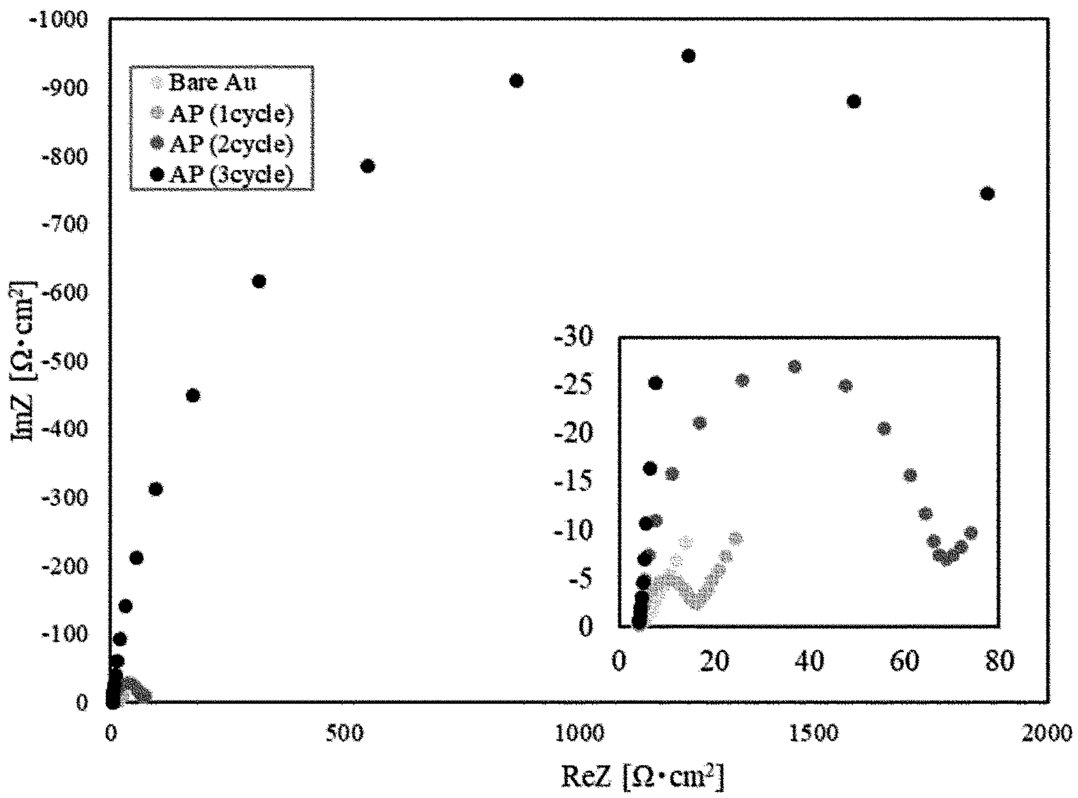
-1000
-900
-800
-700
-600
-500
-400
-300
-200
-100
0
Bare Au
AP (1cycle)
AP (2cycle)
AP (3cycle)
ImZ [Ω·cm$^2$]
-30
-25
-20
-15
-10
-5
0
0
20
40
60
80
0
500
1000
1500
2000
ReZ [Ω·cm$^2$]

FIG.7

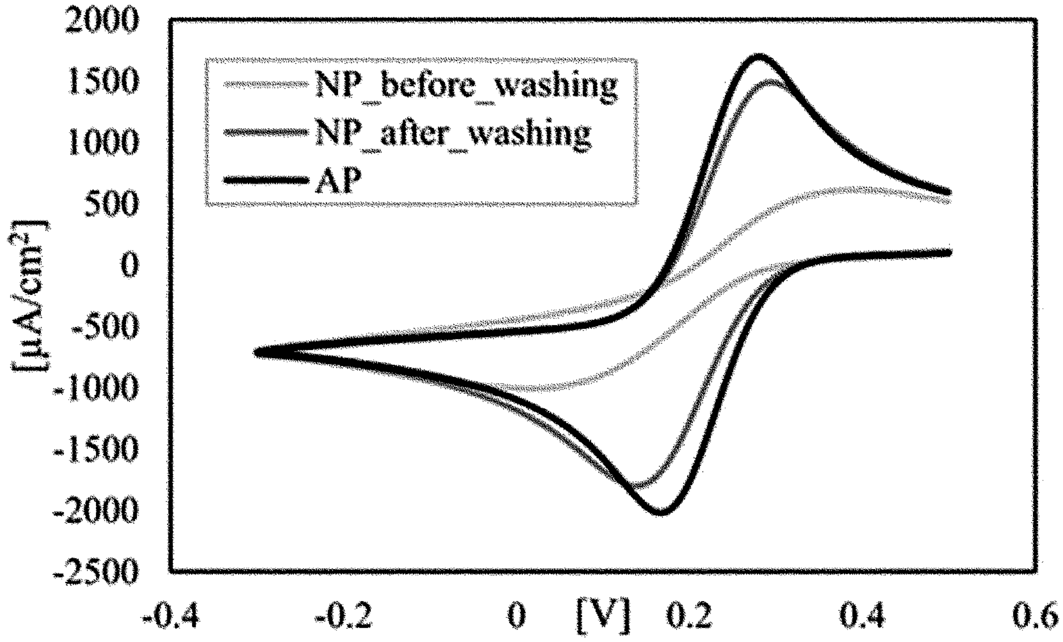
2000
1500
1000
500
0
-500
-1000
-1500
-2000
-2500
[μA/cm2]
NP_before_washing
NP_after_washing
AP
-0.4
-0.2
0
[V]
0.2
0.4
0.6

FIG.8

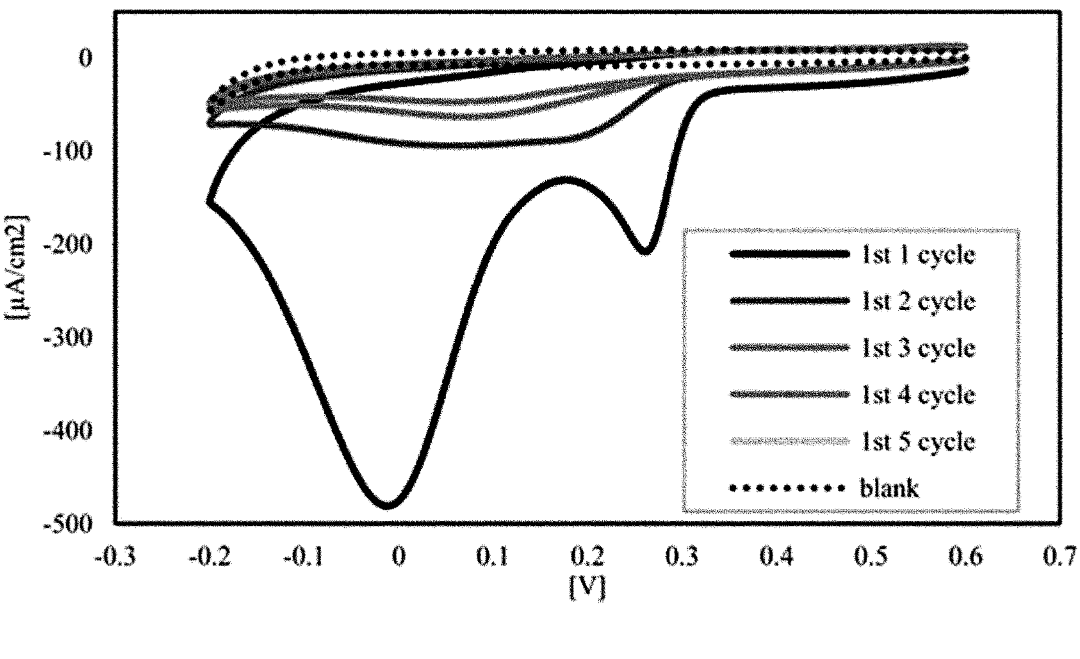
0
-100
-200
-300
-400
-500
[μA/cm2]
1st 1 cycle
1st 2 cycle
1st 3 cycle
1st 4 cycle
1st 5 cycle
blank
-0.3
-0.2
-0.1
0
0.1
0.2
0.3
0.4
0.5
0.6
0.7
[V]

*FIG.9*

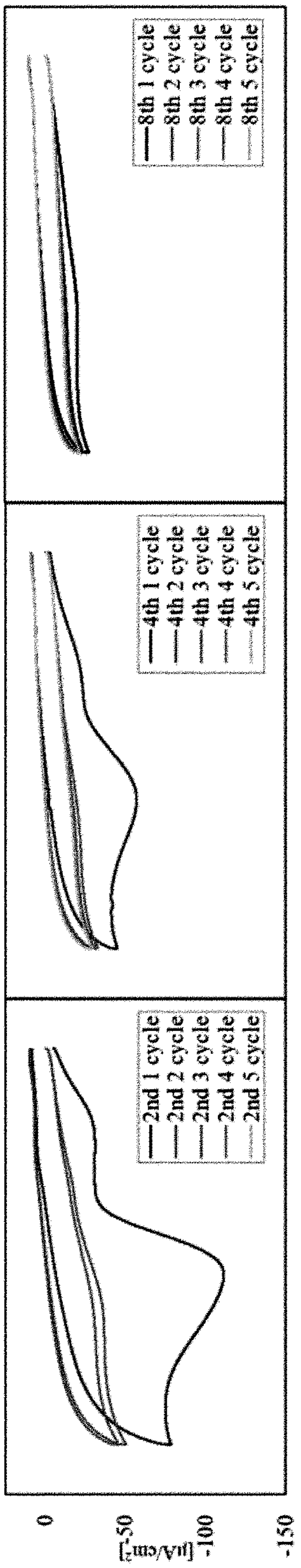
8th 1 cycle
8th 2 cycle
8th 3 cycle
8th 4 cycle
8th 5 cycle
4th 1 cycle
4th 2 cycle
4th 3 cycle
4th 4 cycle
4th 5 cycle
2nd 1 cycle
2nd 2 cycle
2nd 3 cycle
2nd 4 cycle
2nd 5 cycle
0
-50
-100
-150
- [μA/cm²]

FIG.10

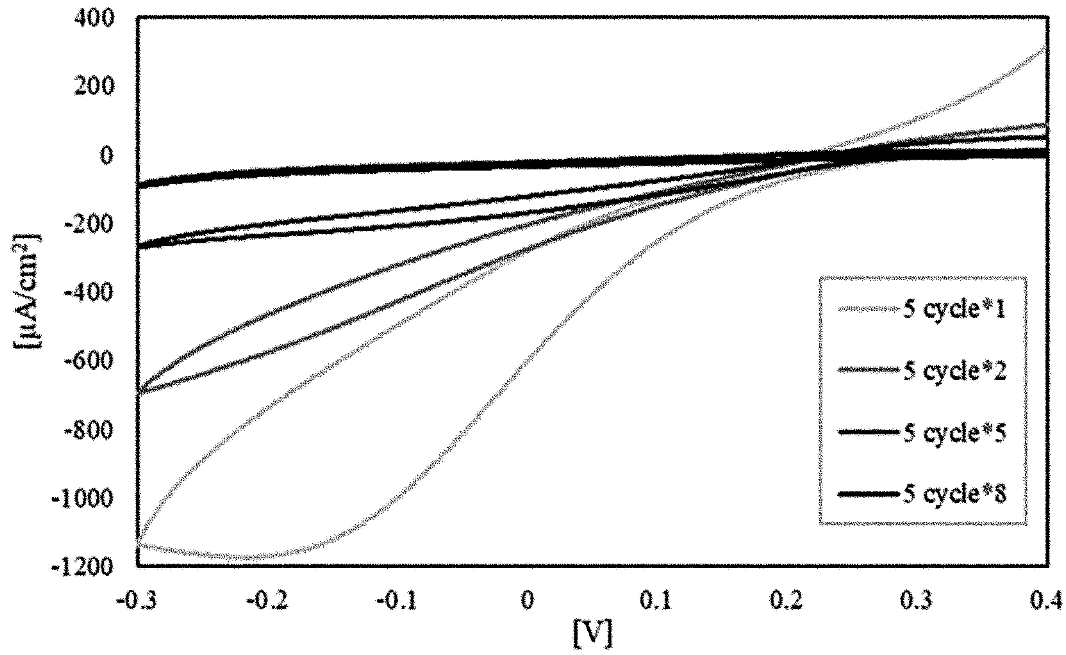
400
200
0
-200
-400
-600
-800
-1000
-1200
[μA/cm²]
-0.3
-0.2
-0.1
0
0.1
0.2
0.3
0.4
[V]
5 cycle*1
5 cycle*2
5 cycle*5
5 cycle*8

FIG.11

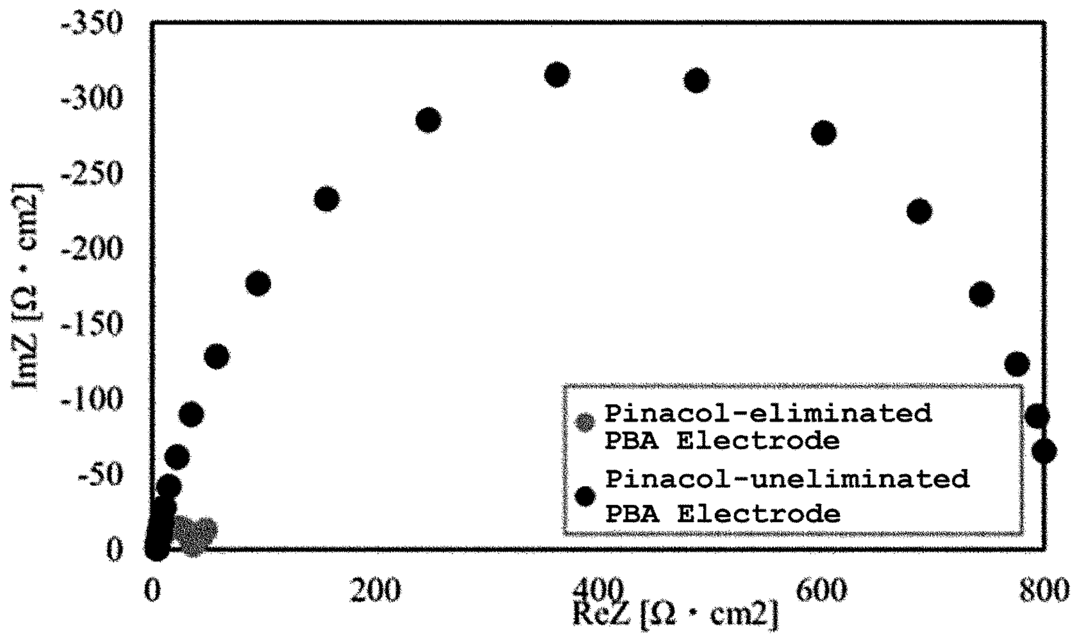
-350
-300
-250
-200
-150
-100
-50
0
ImZ [Ω · cm2]
0
200
400
600
800
ReZ [Ω · cm2]
Pinacol-eliminated PBA Electrode
Pinacol-uneliminated PBA Electrode

FIG.12

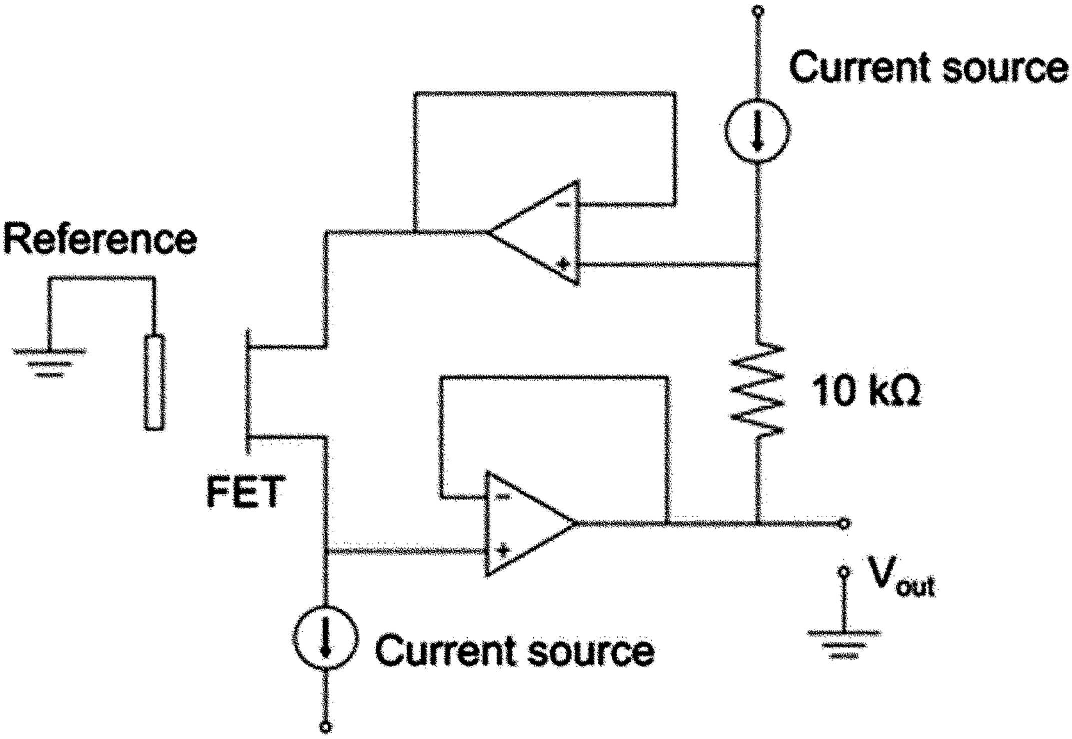

FIG.13

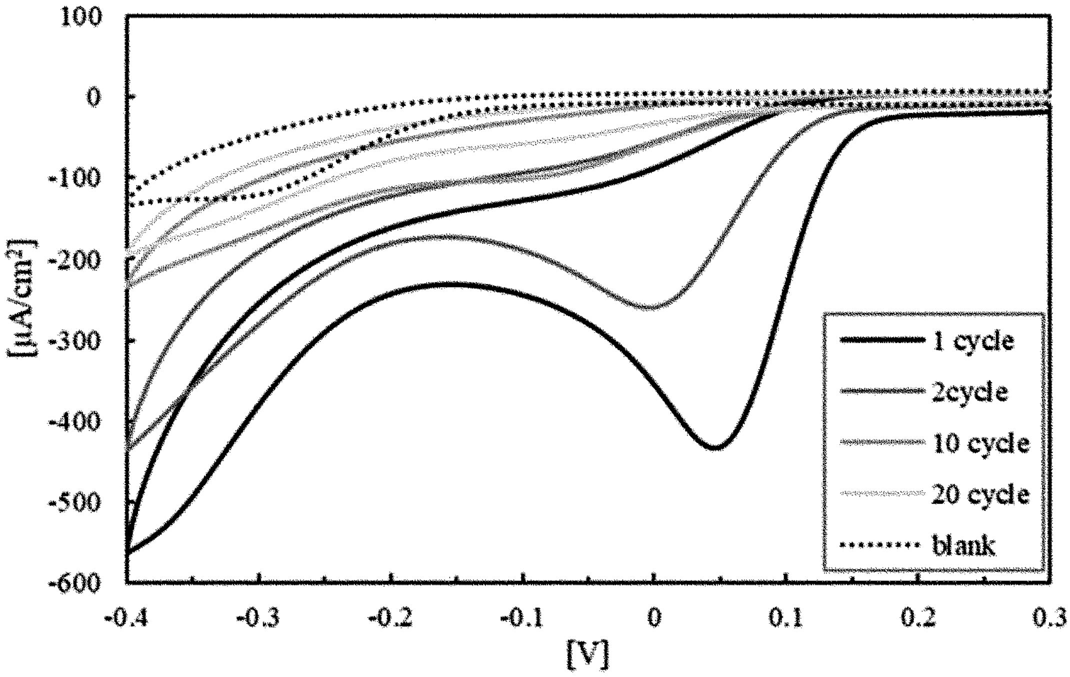
100
0
-100
-200
-300
-400
-500
-600
[μA/cm2]
-0.4
-0.3
-0.2
-0.1
0
0.1
0.2
0.3
[V]
1 cycle
2cycle
10 cycle
20 cycle
blank

FIG.14

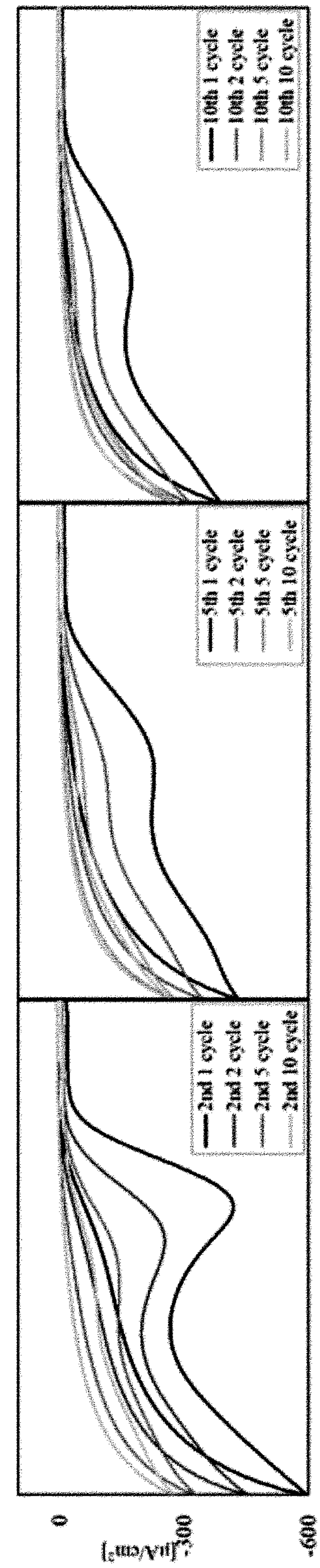
10th 1 cycle
10th 2 cycle
10th 5 cycle
10th 10 cycle
5th 1 cycle
5th 2 cycle
5th 5 cycle
5th 10 cycle
2nd 1 cycle
2nd 2 cycle
2nd 5 cycle
2nd 10 cycle
[V]
-0.4
-0.2
0
0.2
[μA/cm²]
0
-300
-600

FIG.15

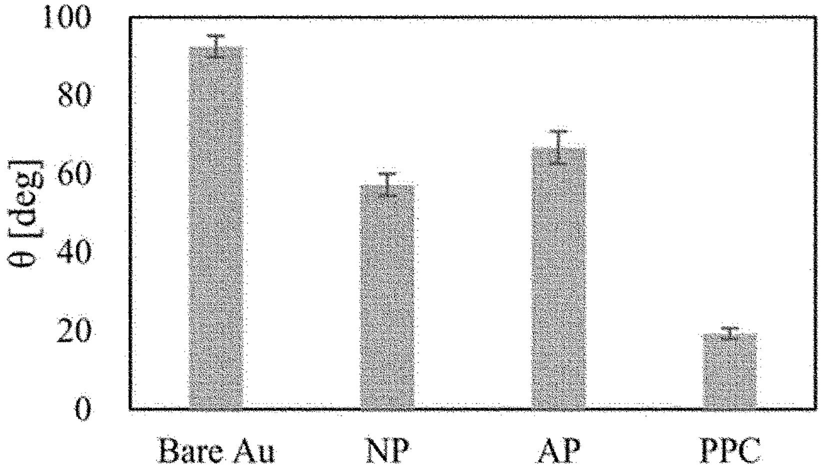
100
80
60
40
20
0
θ [deg]
Bare Au
NP
AP
PPC

FIG.16

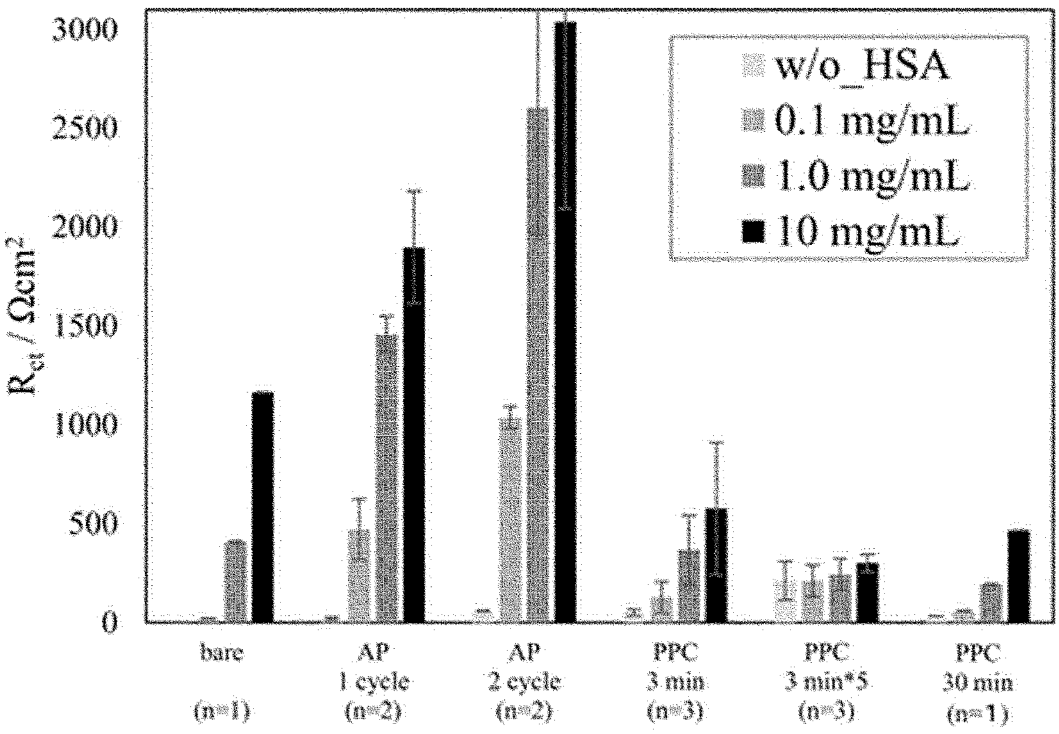
3000
2500
2000
1500
1000
500
0
$R_{ct}$ / $\Omega cm^2$
w/o_HSA
0.1 mg/mL
1.0 mg/mL
10 mg/mL
bare (n=1)
AP 1 cycle (n=2)
AP 2 cycle (n=2)
PPC 3 min (n=3)
PPC 3 min*5 (n=3)
PPC 30 min (n=1)

FIG.17

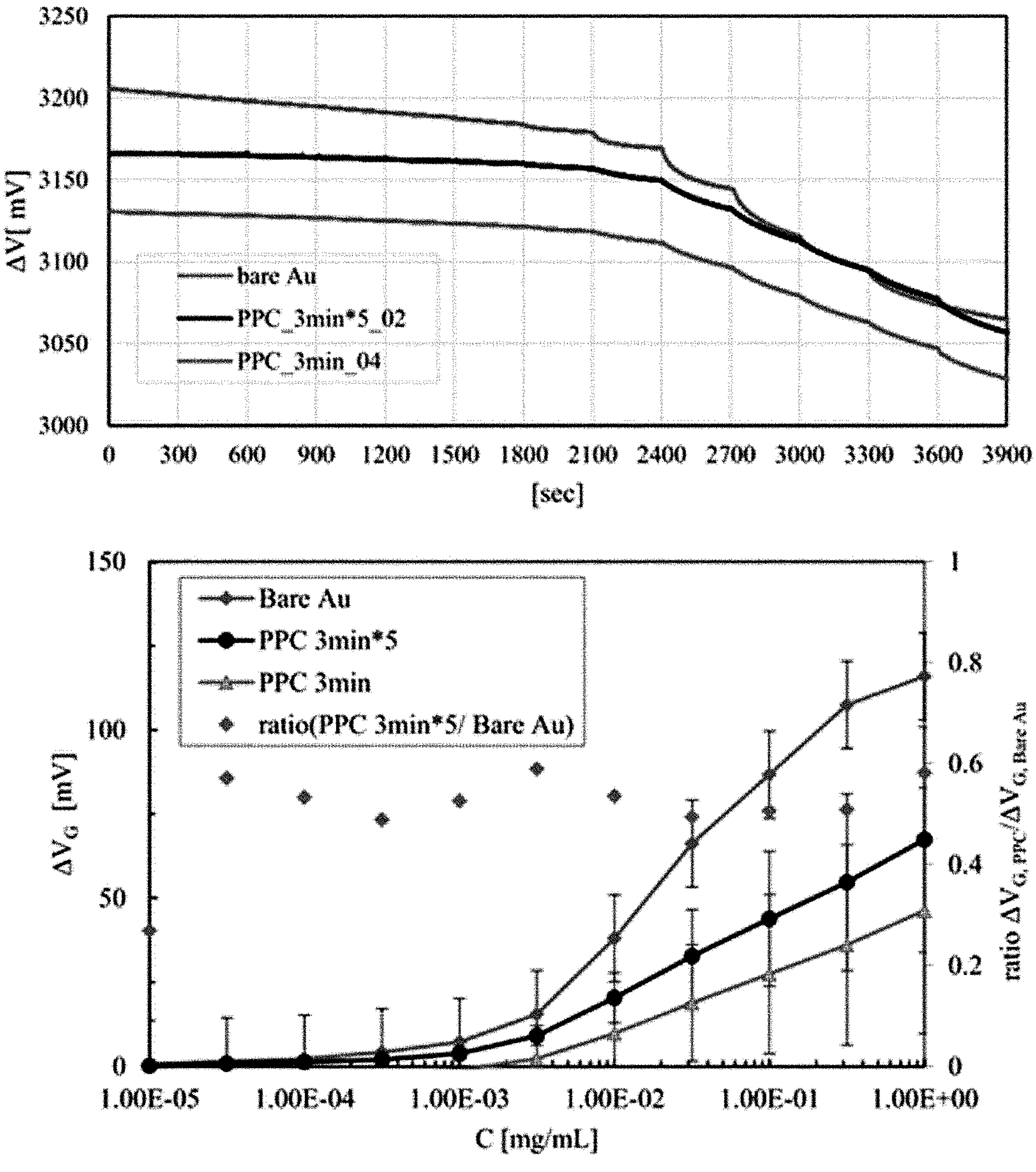
3250
3200
3150
3100
3050
3000
ΔV[ mV]
bare Au
PPC_3min*5_02
PPC_3min_04
0
300
600
900
1200
1500
1800
2100
2400
2700
3000
3300
3600
3900
[sec]
150
100
50
0
$\Delta V_G$ [mV]
Bare Au
PPC 3min*5
PPC 3min
ratio(PPC 3min*5/ Bare Au)
1
0.8
0.6
0.4
0.2
0
ratio $\Delta V_{G, PPC}/\Delta V_{G, Bare Au}$
1.00E-05
1.00E-04
1.00E-03
1.00E-02
1.00E-01
1.00E+00
C [mg/mL]

FIG.18

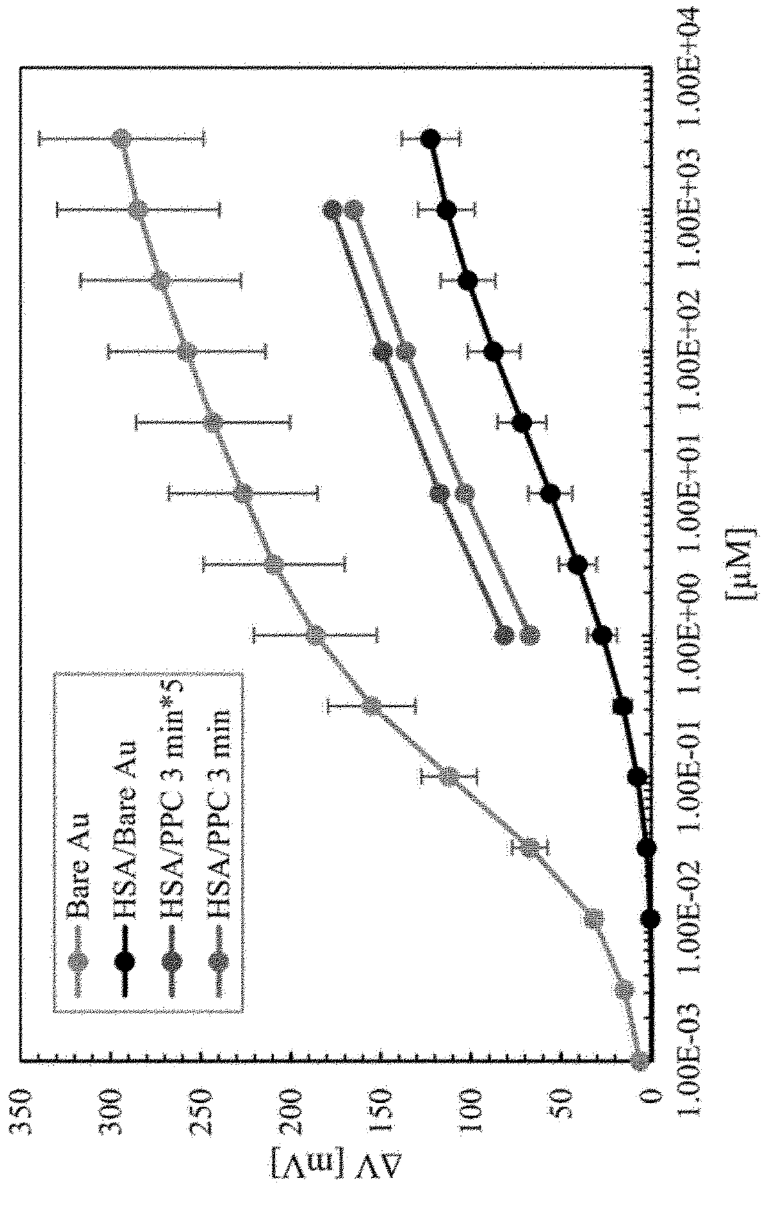
Bare Au
HSA/Bare Au
HSA/PPC 3 min*5
HSA/PPC 3 min
ΔV [mV]
[μM]
0
50
100
150
200
250
300
350
1.00E-03
1.00E-02
1.00E-01
1.00E+00
1.00E+01
1.00E+02
1.00E+03
1.00E+04

*FIG.19*

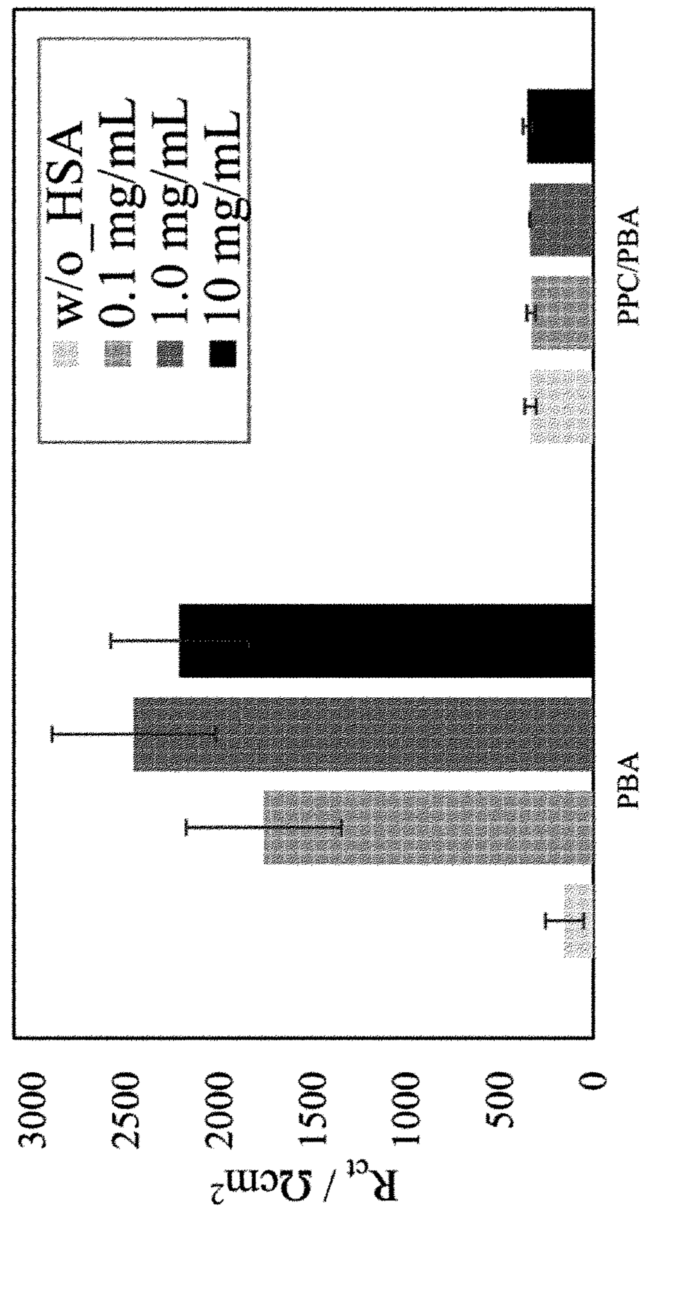

w/o_HSA
0.1 mg/mL
1.0 mg/mL
10 mg/mL
PBA
PPC/PBA
$R_{ct}$ / Ωcm²
3000
2500
2000
1500
1000
500
0

FIG.20

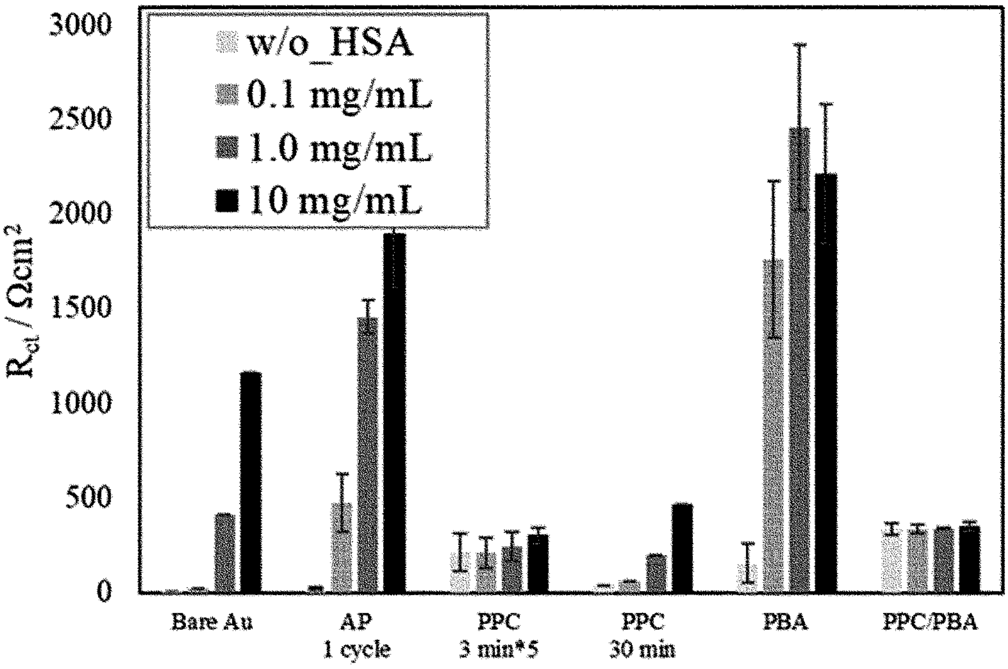

3000
2500
2000
1500
1000
500
0
$R_{ct}$ / Ωcm²
w/o_HSA
0.1 mg/mL
1.0 mg/mL
10 mg/mL
Bare Au
AP
1 cycle
PPC
3 min*5
PPC
30 min
PBA
PPC/PBA


FIG.21

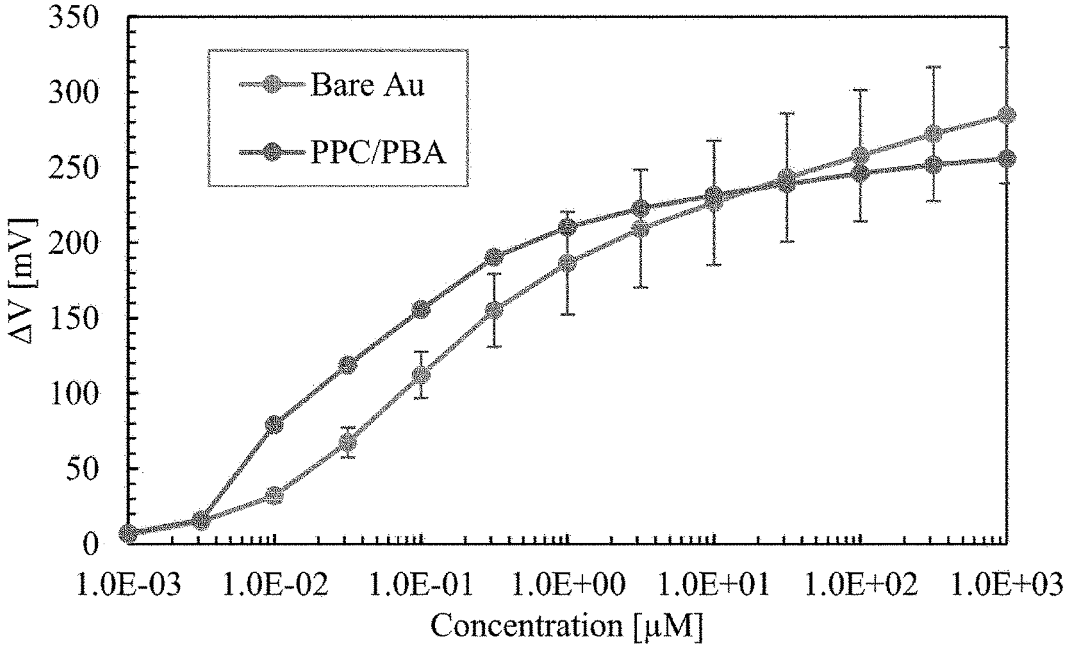

350
300
250
200
150
100
50
0
ΔV [mV]
Bare Au
PPC/PBA
1.0E-03
1.0E-02
1.0E-01
1.0E+00
1.0E+01
1.0E+02
1.0E+03
Concentration [μM]

## INTERNATIONAL SEARCH REPORT

International application No.
**PCT/JP2022/001655**

**A. CLASSIFICATION OF SUBJECT MATTER**

***H01L 29/786***(2006.01)i; ***G01N 27/414***(2006.01)i
FI: G01N27/414 301V; H01L29/78 625; G01N27/414 301P

According to International Patent Classification (IPC) or to both national classification and IPC

**B. FIELDS SEARCHED**

Minimum documentation searched (classification system followed by classification symbols)

H01L29/786; G01N27/414

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580(JDreamIII)

**C. DOCUMENTS CONSIDERED TO BE RELEVANT**

| Category* | Citation of document, with indication, where appropriate, of the relevant passages | Relevant to claim No. |
|---|---|---|
| X | HIMORI, Shogo et al. Control of Potential Response to Small Biomolecules with Electrochemically Grafted Aryl-Based Monolayer in Field-Effect Transistor-Based Sensors. LANGMUIR. 2019, vol. 35, pp. 3701-3709<br>abstract, experimental section, results and discussion | 11-15 |
| A | JP 2019-45417 A (UNIV TOKYO) 22 March 2019 (2019-03-22)<br>entire text, all drawings | 1-15 |
| A | CAO, Chaomin et al. Advances on Aryldiazonium Salt Chemistry Based Interfacial Fabrication for Sensing Applications. ACS APPLIED MATERIALS & INTERFACES. 2017, vol. 9, pp. 5031-5049<br>entire text, all drawings | 1-15 |
| A | JP 2015-34730 A (UNIV TOKYO) 19 February 2015 (2015-02-19)<br>entire text, all drawings | 1-15 |
| P, X | NISHITANI, Shoichi et al. Densification of Diazonium-Based Organic Thin Film as Bioelectrical Interface. LANGMUIR. 02 December 2021, vol. 37, pp. 14369-14379<br>entire text, all drawings | 1-15 |

☐ Further documents are listed in the continuation of Box C. ☑ See patent family annex.

* Special categories of cited documents:
- "A" document defining the general state of the art which is not considered to be of particular relevance
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **28 March 2022** | **12 April 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/001655**

| Patent document cited in search report | Publication date (day/month/year) | Patent family member(s) | Publication date (day/month/year) |
|---|---|---|---|
| JP 2019-45417 A | 22 March 2019 | (Family: none) | |
| JP 2015-34730 A | 19 February 2015 | US 2016/0169835 A1<br>entire text, all drawings<br>EP 3032248 A1<br>EP 3715840 A1<br>CA 2920140 A1<br>CN 105474007 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014215292 A
- JP 2019045417 A


### Non-patent literature cited in the description


- **NISHITANI, S. et al.** *ACS Applied Materials & Interfaces,* 2019, vol. 11, 5561-5569
- **HIMORI, S. et al.** *Langmuir,* 2019, vol. 35, 3701-3709
- **PARVIZ, M. et al.** *Electroanalysis,* 2014, vol. 26, 1471-1480
- **THIAGARAJAN, S. et al.** *Biosensors and Bioelectronics,* 2009, vol. 24 (8), 2712-2715
- **GARROTE et al.** *Nature Protocols,* 2020, vol. 15, 3879-3893